# EUROPEAN PATENT APPLICATION

(11) **EP 4 568 440 A1**
(43) Date of publication of application: **11.06.2025**
(21) Application number: 24194039.4
(22) Date of filing: 12.08.2024
(51) Int. Cl.: H10B 12/00, H10D 30/67

(54) **SEMICONDUCTOR STRUCTURE AND METHOD OF MANUFACTURING SEMICONDUCTOR STRUCTURE**

(30) Priority: 08.12.2023 CN 202311692267
(71) Applicant: SwaySure Technology Co., Ltd., Shenzhen (CN)
(72) Inventor: WANG, Lihan, Shenzhen (CN)
(74) Representative: Studio Torta S.p.A.

(57) **Abstract**

The present application involves a semiconductor structure and a method of manufacturing the semiconductor structure. The semiconductor structure includes a substrate (10) and at least one memory layer (20) stacked on a same side of the substrate (10) in a vertical direction. The memory layer (20) includes at least a first signal line (20a), at least one transistor (20b), a second signal line (20c) and at least one gating line (20d). One of the first signal line (20a) and the second signal line (20c) is a reference voltage line and another one of the first signal line (20a) and the second signal line (20c) is a read-write line. A gate layer (202) of the transistor (20b) is connected to the at least one gating line (20d). An active layer (201) of the transistor (20b) is extended in a vertical direction and is independently provided relative to the substrate (10).

## Description

### TECHNICAL FIELD

The present application belongs to the field of storage, particularly relates to a semiconductor structure and a method of manufacturing the semiconductor structure.

### BACKGROUND

With the shrinkage of the technology node, 1T0C (T represents a transistor, C represents a capacitor) type Dynamic Random Access Memory (DRAM) has become a research hotspot, but the traditional 1T0C type DRAM takes the substrate as the active layer, which is arranged in a plane, i.e. the whole active layer is extended in a horizontal direction, and the memory density of the 1T0C DRAM is increased by shrinking the size of the transistor, which will increase the process difficulty and technical cost.

### SUMMARY

Accordingly, the present application provide a semiconductor structure and a method of manufacturing the semiconductor structure in accordance with claims which follow.

A first aspect of embodiments of the present application, there is provided a semiconductor structure, which includes:
a substrate; and
at least one memory layer, stacked on a same side of the substrate in a vertical direction, wherein the memory layer includes at least a first signal line layer, at least one transistor layer, a second signal line layer and at least one gating line layer, wherein the first signal line layer comprises a plurality of first signal lines spaced apart, each transistor layer comprises a plurality of transistors spaced apart, the second signal line layer comprises a plurality of second signal lines spaced apart, and each gating line layer comprises a plurality of gating lines spaced apart, one of the first signal line and the second signal line is a reference voltage line and another one of the first signal line and the second signal line is a read-write line, wherein
each transistor comprises a gate layer and an active layer which is extended in a vertical direction and independently provided relative to the substrate;

The gate layer is connected to the gating line; a bottom of the active layer is connected to the first signal line, and a top of the active layer is connected to the second signal line.

A second aspect of embodiments of the present application, there is provided a method of manufacturing a semiconductor structure, which includes:
providing a substrate;
forming at least one memory layer stacked on the substrate in a vertical direction, wherein a method of forming each memory layer includes:
forming a first signal line layer, at least one transistor layer, a second signal line layer and at least one gating line layer on the substrate, wherein the first signal line layer comprises a plurality of first signal lines spaced apart, each transistor layer comprises a plurality of transistors spaced apart, the second signal line layer comprises a plurality of second signal lines spaced apart, and each gating line layer comprises a plurality of gating lines spaced apart, one of the first signal line and the second signal line is a reference voltage line and another one of the first signal line and the second signal line is a read-write line, the transistor comprises a gate layer, an active layer which is extended in a vertical direction and independently provided relative to the substrate; wherein the gate layer is connected to the gating line; a bottom of the active layer is connected to the first signal line, and a top of the active layer is connected to the second signal line.

The technical solutions provided by embodiments of the present application have at least the following advantages:
Compared to the solution of utilizing a portion of the substrate as the active layer, by setting up the active layer of the transistor independently relative to the substrate of the semiconductor structure, the present application reduces the design difficulty and technical cost of the three-dimensional transistor (i.e., the whole active layer of the present application is extended in the vertical direction), and also increases the number of transistors per unit area in the memory layer, such that the memory density may be increased, and furthermore, it may facilitate setting up a plurality of the memory layers and stacking them in the vertical direction to further increase the memory density.

### BRIEF DESCRIPTION OF THE DRAWINGS

The accompanying drawings herein are incorporated into and form a part of the specification, illustrate embodiments consistent with the present application, and are used in conjunction with the specification to explain the principles of the present application. Obviously, the accompanying drawings in the following description are only some of the embodiments of the present application, and other drawings may be obtained from these drawings by those skilled in the art without any creative labour.
FIGS. 1 to 3 are views of semiconductor structures in different technical embodiments of the present application, respectively.
FIG. 4 is a sectional view of the semiconductor structure shown in FIG. 1 along the A-A direction.
FIG. 5 is a sectional view of the semiconductor structure shown in FIG. 3 along the B-B direction.
FIGS. 6 to 8 are views of the semiconductor structure including a plurality of common units in different technical embodiments of the present application, respectively.
FIG. 9 is a view of a substrate in a semiconductor structure in the technical embodiments of the present application.
FIG. 10 is a structural view after performing step S2003 in a process of manufacturing a semiconductor structure.
FIG. 11 is a structural view after performing step S2100 in a process of manufacturing the semiconductor structure.
FIG. 12 is a sectional view of the structure in FIG. 10 along a C-C direction or along a D-D direction.
FIG. 13 to 21 are structural views of a third solution of the present application after different steps have been performed, respectively.
FIG. 22 to 32 are structural views of a fourth solution of the present application after different steps have been performed, respectively.

### DETAILED DESCRIPTION OF THE EMBODIMENTS

Embodiments will now be described more fully with reference to the accompanying drawings. However, the embodiments can be implemented in a variety of forms and should not be construed as limitation to the examples set forth herein; rather, the provision of these embodiments allows the present application to be more comprehensive and complete and conveys the idea of the embodiments in a comprehensive manner to those skilled in the art.

In addition, the described features, structures, or characteristics may be combined in one or more embodiments in any suitable manner. In the following description, many specific details are provided thereby giving a full understanding of the embodiments of the present application. However, those skilled in the art will realize that it is possible to practice the technical embodiments of the present application without one or more of the specific details, or that other methods, components, devices, steps, etc. may be employed. In other cases, the well-known methods, devices, implementations, or operations are not shown or described in detail to avoid blurring aspects of the present application.

The present application is described in further detail below in connection with the accompanying drawings and specific embodiments. It should be noted herein that the technical features involved in the various embodiments of the present application described below may be combined with each other as long as they do not constitute a conflict with each other. The embodiments described below by reference to the accompanying drawings are exemplary and are intended to be used to explain the present application and are not to be construed as a limitation of the present application.

The present application provides a semiconductor structure, which may include a DRAM, but is not limited thereto and is not overly limited herein.

The semiconductor structure of the present application is described in detail below in conjunction with the accompanying drawings.

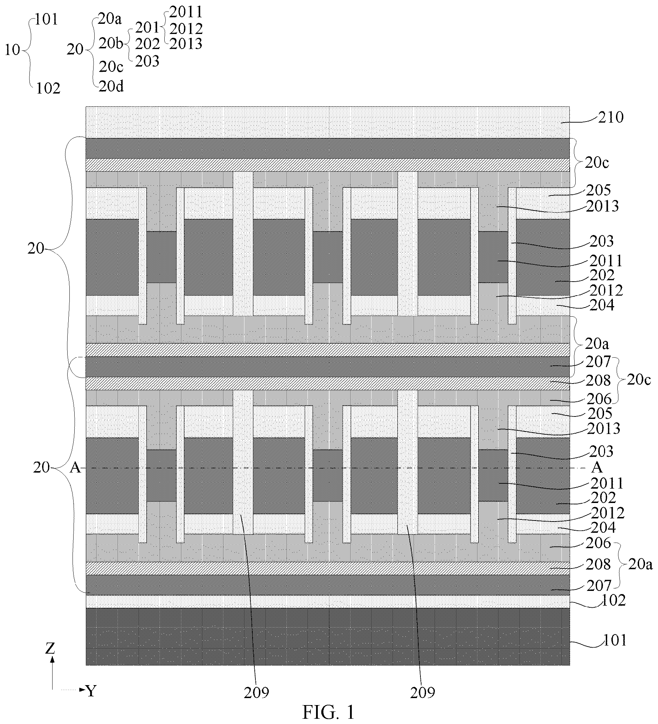

Referring to FIGS. 1 to 3, the semiconductor structure may include a substrate 10 and a memory layer 20 formed on the substrate 10.

For example, the substrate 10 may include at least a single-crystal semiconductor material layer 101 and an insulating isolation layer 102 formed between the memory layer 20 and the single-crystal semiconductor material layer 101. In this embodiment, the material of the single-crystal semiconductor material layer 101 may include single-crystal semiconductor materials such as single-crystal silicon, germanium (Ge), but is not limited thereto. The material of the insulating isolation layer 102 may be silicon oxide, for example, silicon dioxide (SiO₂), but is not limited thereto. The insulating isolation layer 102 may also be made of other materials with insulating properties, which is determined on the actual situation.

In the process of preparing the silicon dioxide as the insulating isolation layer 102, Tetraethoxysilane (TEOS) may be used as the silicon source in the chemical vapour deposition (CVD) process. In the chemical vapour deposition process, TEOS and oxygen react on the surface of the single-crystal semiconductor material layer 101 under a certain temperature and pressure to produce silicon dioxide and ethanol. In this process, silicon atoms in the TEOS molecule react with oxygen to form silicon dioxide and release ethanol. The silicon dioxide as a deposit is formed on the surface of the single-crystal semiconductor material layer 101 to form a film of silicon dioxide as the insulating isolation layer 102.

It will be appreciated that the substrate 10 may be a peripheral substrate, a support substrate, or a bonding substrate.

The present application is hereinafter mainly described as an example in which the memory layer 20 is formed on the substrate 10, i.e., the substrate 10 is a support substrate.

The memory layer 20 may include a first signal line layer, at least one transistor layer, a second signal line layer, and at least one gating line layer. The first signal line layer includes a plurality of first signal lines 20a spaced apart, each transistor layer includes a plurality of transistors 20b spaced apart, the second signal line layer includes a plurality of second signal lines 20c spaced apart, and each gating line layer includes a plurality of gating lines 20d spaced apart. Each transistor20b includes a gate layer 202 and an active layer 201 which is extended in a vertical direction and independently provided relative to the substrate 10.

Referring to FIGS. 1 to 3, the transistor 20b at least includes an active layer 201, a gate layer 202, and a gate insulating layer 203 filled between the gate layer 202 and the active layer 201. The active layer 201 of the present embodiment may be extended in the vertical direction Z, which may be a direction perpendicular or nearly perpendicular to the substrate 10, i.e., the active layer 201 may be perpendicular or nearly perpendicular to the substrate 10.

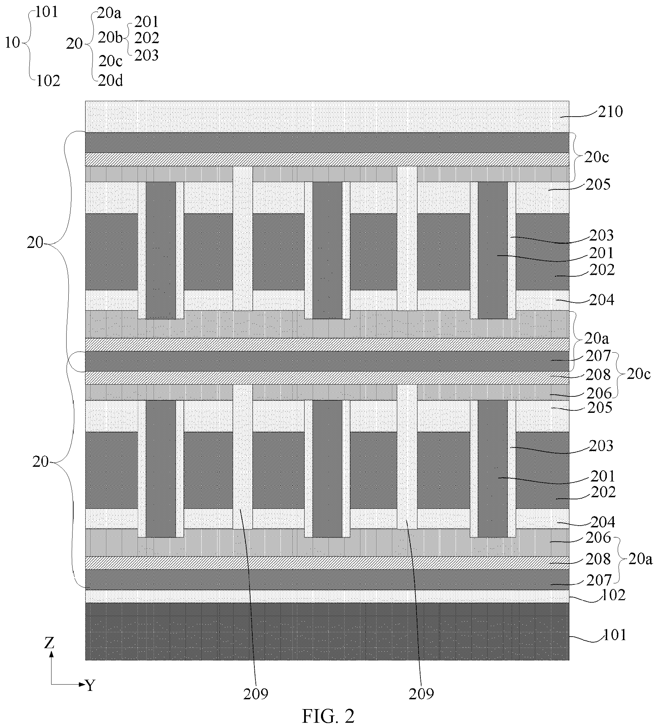

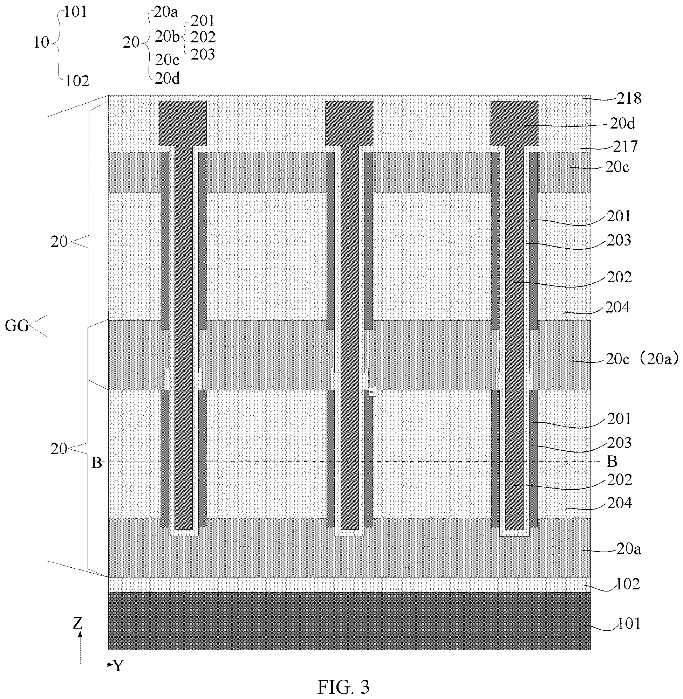

Exemplarily, the whole transistor 20b in this embodiment may be a three-dimensional structure to increase the memory density per unit area, and to increase the channel width and the read-write current of the transistor 20b in the memory layer 20, and can improve the control capability of the gate by increasing the channel length in the vertical direction. Specifically, the transistor 20b includes a core layer and a sleeve layer, and the sleeve layer at least surrounds an outer periphery of the core layer, and both the core layer and the sleeve layer as a whole are extended in the vertical direction Z. One of the core layer and the sleeve layer is the active layer 201 of the transistor 20b, and the other is the gate layer 202 of the transistor 20b. When the sleeve layer is the gate layer 202 and the core layer is the active layer 201, and Referring to FIGS. 1 and 2, the transistor 20b is then understood to be a gate surrounding structure. When the sleeve layer is the active layer 201 and the core layer is the gate layer 202, the transistor 20b is understood to be a channel surrounding structure as shown in FIG. 3.

In the present application, the active layer 201 is made of a semiconductor material, and specifically a polycrystalline semiconductor material, for example, such as polycrystalline (Poly) silicon. It should be understood that the active layer 201 is not limited to the semiconductor material mentioned before, as long as the semiconductor material can achieve full depletion, and exemplarily, the active layer 201 can also be indium gallium zinc oxide (IGZO). The gate layer 202 can be made of a metal material, for example, copper, tungsten, etc., in order to improve the conductivity, but it is not limited thereto, and other materials that have good conductivity can be used, which is determined on the specific needs.

In an optional embodiment, as shown in FIG. 1, the active layer 201 may be a junction active layer to make the transistor 20b to be a junction transistor. The junction transistor is a transistor with a junction structure formed by using semiconductor materials of different conductivity types (i.e. doping types) to form a channel region and a source-drain region in the semiconductor device. Specifically, the active layer 201 of the present embodiment may include a channel region 2011, and a first electrode region 2012 and a second electrode region 2013 provided on two opposite sides of the channel region 2011 in the vertical direction Z. It is to be noted that one of the first electrode region 2012 and the second electrode region 2013 is a source region, and the other is a drain region.

The first electrode region 2012 may be formed between the first signal line layer and the channel region 2011, i.e., a top of the first electrode region 2012 is in contact with a bottom of the channel region 2011, and a bottom of the first electrode region 2012 is in contact with a top of the first signal line layer. The second electrode region 2013 may be formed between the second signal line layer and the channel region 2011, i.e., a bottom of the second electrode region 2013 is in contact with a top of the channel region 2011, and a top of the second electrode region 2013 is in contact with a top of the second signal line layer.

In this embodiment, conductive types of the first electrode region 2012 and the second electrode region 2013 are the same, e.g., both are N-type semiconductors or P-type semiconductors. The conductive types of the first electrode region 2012 and the second electrode region 2013 are both different from the conductive types of the channel region 2011, thereby forming the junction active layer 201. For example, when the conductive types of the first electrode region 2012 and the second electrode region 2013 are the N-type semiconductors, the channel region 2011 is the P-type semiconductor, at this time, the transistor 20b may be an N-Metal-Oxide-Semiconductor (NMOS) transistor. When the conductive types of the first electrode region 2012 and the second electrode region 2013 are the P-type semiconductors, the conductive type of the channel region 2011 is the N-type semiconductor, at this time, the transistor 20b may be a P-Metal-Oxide-Semiconductor (PMOS) transistor, such that a PN junction is formed between the channel region 2011 and the first electrode region 2012, and a PN junction is formed between the channel region 2011 and the second electrode region 2013.

When the active layer 201 of the transistor 20b is the junction active layer as mentioned above, in order to realize the charge storage function of the transistor in the memory layer 20, such that the gate layer 202 can correspond to the channel region 2011 of the active layer 201. Specifically, as shown in FIG. 1, a top surface of the first electrode region 2012 in the active layer 201 is higher than a bottom surface of the gate layer 202. A bottom surface of the second electrode region 2013 is lower than a top surface of the gate layer 202, such that the junction formed between the channel region 2011 and the first electrode region 2012 (i.e., the position where the channel region 2011 is in contact with the first electrode region 2012), and the junction formed between the channel region 2011 and the second electrode region 2013 (i.e., the position where the channel region 2011 is in contact with the second electrode region 2013) both correspond to the gate layer 202. Therefore, the design and position of the gate layer 202 needs to correspond to the junction of the active layer 201 during the manufacturing of the transistor 20b to ensure normal work of the device.

In another optional embodiment, the active layer 201 may also be a junctionless active layer, as shown in FIG. 2, the junctionless active layer is a semiconductor active layer without a PN junction, which usually consists of a continuous semiconductor film. When the active layer 201 is the junctionless active layer, the transistor 20b formed may be a junctionless transistor or a junction transistor. Compared to the junction active layer, the junctionless active layer does not require the step of patterning doped source-drain regions or channel regions, and thus the manufacturing process is relatively simple, the manufacturing cost can be reduced and the production efficiency can be improved. When the active layer 201 is the junctionless active layer and its' material is doped polycrystalline silicon, the signal line in contact with the active layer 201 may include a semiconductor layer with an opposite doping type to the active layer 201, so that the formed transistor 20b is the junction transistor.

It should be noted that the performance of the junctionless transistor is affected by a variety of factors, such as the quality of the material, the thickness of the film, and the doping concentration. Therefore, in practice, the design needs to be optimized according to specific application scenarios and requirements in order to achieve the best performance.

Referring to FIG. 1 or FIG. 2, in the present application, the active layer 201 may be formed at the top of the first signal line layer, and the second signal line layer may be formed at the top of the active layer 201, that is, the active layer 201 may be provided between the first signal line layer and the second signal line layer. The top of the active layer 201 is connected to the second signal line layer, and the bottom of the active layer 201 is connected to the first signal line layer.

It is to be noted that the top and the top surface of a certain structure in the present application refer to an end of the certain structure away from the substrate 10 or a surface of the certain structure away from the substrate 10, and the bottom and the bottom surface of the certain structure refer to an end of the certain structure close to the substrate 10 or a surface of the certain structure close to the substrate 10.

One of the first signal line 20a and the second signal line 20c is a reference voltage line, and the other is a read-write line. The read-write line is connected to the peripheral circuitry to input or output the stored signal, and the gating line 20d is connected to the gate layer 202 of the transistor 20b. Different voltages are applied between the read-write line and the gating line 20d, such that the reading and writing of data in the transistor 20b can be achieved.

Exemplarily, the reference voltage line may be a ground line with a reference voltage of 0 V Subsequent embodiments of the present invention are also illustrated with a reference voltage of 0 V as an example.

Exemplarily, taking the transistor 20b as the NMOS transistor as an example, the read-write operation of the transistor 20b is illustrated as follows:
In the process of writing " 1", a negative voltage is applied to the gate layer 202 of the transistor 20b via the gating line 20d, and a positive voltage is applied to the drain region of the transistor 20b via the read-write line, and holes generated by the Gate Induced Drain Leakage (GIDL) in the depletion region at the overlap of the drain region and the gate layer are accumulated in the float region.

In the process of reading "0" or " 1", a positive voltage is applied to the gate layer 202 of the transistor 20b via the gating line 20d, and a suitable positive voltage is applied to the drain region of the transistor 20b via the read-write line, and this suitable positive voltage is a small voltage to make the work of the NMOS transistor be in the linear region, to prevent from producing Hot Carrier Injection effect (HCl), which leads to ionization. If there is a hole accumulated in the floating body, then the threshold voltage of the transistor 20b is lower, the drain current is larger, and at this time it is reading "1". If there is no hole accumulated in the floating body, the threshold voltage of the transistor 20b is higher and the drain current is lower, and at this time it is reading "0". The difference value between the drain current when reading "1" and the drain current when reading "0" is the sense margin.

In the process of writing "0", a positive pressure is applied to the gate layer 202 of the transistor 20b via the gating line 20d, and a negative pressure is applied to the drain region of the transistor 20b via the read-write line, so that the PN junction from the drain region to the channel region is positively biased and conducted, electrons and holes are compounded to eliminate holes.

In the process of selectively writing "0", a small positive voltage is applied to the gating line 20d connected to the selected transistor 20b at " 1", so that the potential of the floating body of the transistor 20b rises. Assuming that a turn-on voltage of the PN junction of the transistor 20b accumulated with holes from the drain region to the channel region is 0.7V, a small voltage is applied to the gate layer 202 of the selected transistor 20b, so that the turn-on voltage of the PN junction from the drain region to the channel region is 0.5V, and then a negative voltage is applied to the read-write line connected to the selected transistor 20b, the negative voltage not only ensures that the drain end of the selected transistor will be turned on, but also ensures that the transistor whose the gate layer is not applied by a voltage is turned off, and then writing "0" is completed.

The process of "Hold": the drain of the transistor is connected to 0V via the read-write line.

It should be noted that in the above process, the source region of each transistor 20b is connected to a reference voltage via a reference voltage line, and the reference voltage can be a fixed voltage or grounded, and the "hold" mentioned above is to keep the state of the transistor unchanged, so that the stored data can be correctly obtained in the subsequent reading process.

Based on the foregoing, in the present application, each transistor 20b itself can act as a memory unit without additional storage capacitors, that is, the memory unit of the memory layer 20 in the present application can be a 1T0C type memory unit.

Exemplarily, as shown FIGS. 1 and 2, if the transistor 20b is a gate surrounding structure, the gating line 20d may be formed on a side of the second signal line 20c close to the substrate 10, that is, the gating line 20d may be formed between the first signal line 20a and the second signal line 20c, such design can use a portion of the gating line 20d as the gate layer 202 of the transistor 20b. That is, the manufacturing of the gate layer 202 in the transistor 20b can be accomplished while the gating line 20d is is fabricated, in order to save manufacturing steps and reduce manufacturing difficulty and cost. It should be understood that, as shown in FIGS. 1 and 2, the gating line 20d needs to be insulated from the first signal line 20a and the second signal line 20c. Therefore, a first insulating dielectric layer 204 may be formed between the gating line 20d and the first signal line 20a, and a second insulating dielectric layer 205 may be formed between the gating line 20d and the second signal line 20c.

Exemplarily, as shown in FIG. 3, if the transistor 20b is the channel surrounding structure, since the gate layer 202 of the transistor 20b is surrounded by the active layer 201, the gating line 20d may be formed on a top side or a bottom side of the gate layer 202 in order to facilitate the connection of the gating line 20d to the gate layer 202 of the corresponding transistor 20b. If the gating line 20d is formed on a top side of the gate layer 202, then the gating line 20d may be located on a side of the second signal line 20c away from the substrate 10, and if the gating line 20d is formed at the bottom side of the gate layer 202, then the gating line 20d may be located on a side of the first signal line 20a close to the substrate 10.

In the present application, since the active layer 201 is made of a semiconductor material, thus when designing the first signal line layer and the second signal line layer, as shown in FIGS. 1 and 2, the first signal line layer and the second signal line layer can be designed to include at least the semiconductor material layer 206. The bottom of the active layer 201 is in direct contact with the semiconductor material layer 206 of the first signal line layer. The top of the active layer 201 is in direct contact with the semiconductor material layer 206 of the second signal line layer. Taking that the semiconductor material is the polycrystalline silicon as an example, the contact area between the polycrystalline silicon and the metal silicides in the first signal line layer and the second signal line layer can be increased to reduce the impedance. The setting of the metal silicides in the first signal line layer and the second signal line layer will be described later.

When the active layer 201 is the junctionless active layer as mentioned above, the conductive type of the active layer 201 may be the same as the conductive type of the semiconductor material layers 206 in the first signal line layer and the second signal line layer, to form the junctionless memory unit, e.g., the active layer 201 and the semiconductor material layer 206 in the first signal line layer and the second signal line layer are both N-type semiconductors, or the active layer 201 and the semiconductor material layer 206 in the first signal line layer and the second signal line layer are both P-type semiconductors, such that the manufacturing costs can be reduced and the production efficiency can be improved.

No limitation herein, when the active layer 201 is the junctionless active layer as mentioned above, the conductive type of the active layer 201 may be different from the conductive types of the semiconductor material layers 206 in the first signal line layer and the second signal line layer, to form the junction transistor as the memory unit. In the embodiment in which the transistor 20b as shown in FIG. 3 is a gate surrounding structure, when the active layer 201 is the N-type semiconductor, the conductive types of the semiconductor material layers 206 in the first signal line layer and the second signal line layer both are the P-type semiconductors, or when the active layer 201 is the P-type semiconductor, the conductive types of the semiconductor material layers 206 in the first signal line layer and the second signal line layer both are the N-type semiconductors, so that the PN junction structure is formed between the semiconductor material layer 206 of the first signal line layer and the active layer 201, and formed between the semiconductor material layer 206 of the second signal line layer and the active layer 201, but in this case, it is necessary to make the gate layer 202 to be opposite to the PN junction structure. When the gating line layer is formed on a top side of the gating layer 202, the bottom surface of the active layer 201 is higher than the bottom surface of the gate layer 202, i.e., the bottom of the gate layer 202 in the transistor 20b is closer to the substrate 10 relative to the bottom of the active layer 201. When the gating line layer is formed on the bottom side of the gate layer 202, the top surface of the active layer 201 is lower than the top surface of the gate layer 202, i.e., the top of the gate layer 202 in the transistor 20b is further away from the substrate 10 relative to the top of the active layer 201. In a positive projection on the substrate 10, the gating line layer covers at least a portion of an outer boundary of the active layer 201. Preferably, the gating line layer completely covers the outer boundary of the active layer 201. The outer boundary refers to a junction between the active layer 201 and the second signal line layer, or it can be appreciated that when the second signal line 20c serves as a read-write line, the channel and the drain of the transistor 20b form the PN junction.

Furthermore, when the active layer 201 is the junction active layer as mentioned above, the semiconductor material layer 206 of the first signal line layer may be of the same conductive type as the first electrode region 2012 in the active layer 201, and the semiconductor material layer 206 of the first signal line layer may be in contact with the first electrode region 2012 of the active layer 201. The semiconductor material layer 206 of the second signal line layer may be of the same conductive type as the second electrode region 2013 in the active layer 201, and the semiconductor material layer 206 of the second signal line layer may be in contact with the second electrode region 2013 of the active layer 201. Taking that the semiconductor material is the polycrystalline silicon as an example, the contact area between the polycrystalline silicon and the metal silicides in the first signal line layer and the second signal line layer can be increased to reduce the impedance. It is understood that in other embodiments, the semiconductor material layer 206 may not be formed between the metal silicides in the first signal line layer and the first electrode region 2012, and formed between the metal silicides in the second signal line layer and the second electrode region 2013 to simplify the process, which can be determined based on actual situations.

It should be noted that the junction formed at the source region, i.e., the junction on a side of the ground line, may or may not be covered by the gate layer 202, but the junction formed at the drain region, i.e., the junction on a side of the read-write line, must be covered by the gate layer 202.

In the present application, where the active layer 201 is made of a polycrystalline semiconductor material, the semiconductor material layer 206 in the first signal line layer and the second signal line layer may also be made of the polycrystalline semiconductor material, e.g., when the active layer 201 is made of polycrystalline silicon, the semiconductor material layer 206 is also made of the polycrystalline silicon.

Exemplarily, in order to improve the conductivity of the first signal line layer and the second signal line layer, as shown in FIGS. 1 and 2, the first signal line layer and the second signal line layer may further include a metal conductive material layer 207, the metal conductive material layer 207 is provided on a side of the semiconductor material layer 206 away from the active layer 201. Further, in order to reduce the contact resistance between the metal conductive material layer 207 and the semiconductor material layer 206, as shown in FIGS. 1 and 2, the first signal line layer and the second signal line layer may also include a transition conductive material layer 208, which is formed between the semiconductor material layer 206 and the metal conductive material layer 207. The material of the transition conductive material layer 208 includes a metal element in the metal conductive material layer 207 and a semiconductor material element in the semiconductor material layer 206.

For example, when the semiconductor material layer 206 is made of polycrystalline silicon, the transition conductive material layer 208 may be made of the metal silicide as mentioned above, e.g., when the metal conductive material layer 207 is made of tungsten, the transition conductive material layer 208 may be made of tungsten silicide (WSi₂) to reduce the contact resistance between the semiconductor material layer 206 of polycrystalline silicon material and the metal conductive material layer 207.

It should be understood that when the active layer 201 is not made of polycrystalline silicon, the transition conductive material layer 208 made of metal silicide may not be provided based on the actual situation. For example, when the active layer 201 is made of an oxide semiconductor such as IGZO, the material of the first signal line layer and the second signal line layer may include only the metal conductive material layer 207 without the transition conductive material layer 208. The active layer 201 is in direct contact with the metal conductive material layer 207.

In addition, it is also noted that if the resistivity of the semiconductor material layers 206 in the first signal line layer and the second signal line layer meets the demand, the first signal line layer and the second signal line layer may be made of semiconductor material only, as shown in FIG. 3.

Exemplarily, the gating line may be made of a metal material, such as copper, tungsten, etc., to improve the conductivity, but is not limited thereto, and other materials with good conductivity may be used, which is determined based on the specific needs.

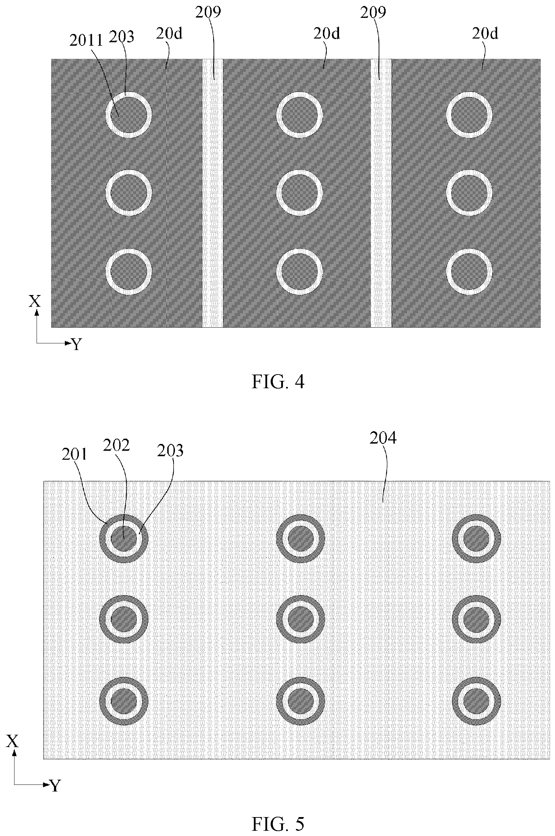

In the present application, in order to improve the memory density of the memory layer 20, the present embodiment may sets up a plurality of transistors 20b in the memory layer 20. The plurality of transistors 20b may be arrayed in a first horizontal direction X and a second horizontal direction Y, as shown in FIGS. 4 and 5. A plurality of the read-write lines (i.e., the first signal line 20a or the second signal line 20c) and a plurality of the gating lines 20d may also be provided, as shown in FIGS. 1 and 4. The gating line 20d may be extended in the first horizontal direction X and the read-write line may be extended in the second horizontal direction Y The plurality of read-write lines may be spaced apart in the first horizontal direction X, and the plurality of gating lines 20d may be spaced apart in the second horizontal direction Y

As shown in FIGS. 1 to 3, the active layers 201 of the plurality of transistors 20b arrayed in the second horizontal direction Y may be connected to a same read-write line, as shown in FIGS. 1 and 4, the gate layer 202 of each transistor 20b arrayed in the first horizontal direction X may be connected to the same gating line 20d, such design may reduce the number of read-write lines and the gating lines while independently controlling the memory unit to perform read-write operations, thereby reducing the planar space occupied by read-write lines and the gating lines, and then the number of transistors 20b may be increased within the limited planar space to further increase the memory density.

It should be noted that the first horizontal direction X and the second horizontal direction Y are parallel or nearly parallel to the substrate 10. The first horizontal direction X intersects with the second horizontal direction Y. Exemplarily, the first horizontal direction X and the second horizontal direction Y are perpendicular or nearly perpendicular to each other. In other embodiments, the angle between the first horizontal direction X and the second horizontal direction Y may be an acute or obtuse angle.

Further, since the active layer 201 of the transistor 20b in the memory layer 20 is independently provided relative to the substrate 10, that is, the active layer 201 of the transistor 20b in the memory layer 20 in the present application needn't to be formed by using a portion of the substrate 10, such that the entire memory layer 20 can be independently provided relative to the substrate 10, which allows a plurality of memory layers 20 to be provided on the same substrate 10, as shown in FIGS. 1 to 3. The plurality of memory layers 20 may be stacked on the same side of the substrate 10 along the vertical direction Z, to increase the memory density of the entire semiconductor structure.

In addition, the design relationship between the plurality of memory layers 20 may be different for different structures of the transistor 20b, such as contents recited in the first solution and the second solution below.

### First solution

In the first solution, with reference to FIGS. 1, 2, and 4, the transistor 20b is shown as a gate surrounding structure as mentioned above, and the gating line layer is provided between the first signal line layer and the second signal line layer. Therefore, in order to reduce the manufacturing difficulty, when manufacturing the plurality of memory layers 20, the gating lines 20d of any two memory layers 20 may be provided independently to each other, so that any two memory layers 20 are controlled independently to each other.

Based on this, in order to simplify the manufacturing process, at least two adjacent memory layers 20 may share a signal line when manufacturing the plurality of memory layers 20. Specifically, in the two adjacent memory layers 20: the memory layer 20 away from the substrate 10 is defined as a top memory layer, and the memory layer 20 close to the substrate 10 is defined as a bottom memory layer. As shown FIGS. 1 and 2, at least a portion of the second signal line 20c in the bottom memory layer is shared as at least a portion of the first signal line 20a in the top memory layer, i.e., the first signal line 20a of the top memory layer and the second signal line 20c of the bottom memory layer may be used as the same signal line, e.g., the same reference voltage line or the same read-write line. It will be appreciated that in other embodiments, the read-write signal line and/or the reference voltage line have no common portion.

For example, if the first signal line 20a of the top memory layer and the second signal line 20c of the bottom memory layer in any two adjacent memory layers 20 are shared as the reference voltage line, the second signal line 20c of the top memory layer and the first signal line 20a of the bottom memory layer are both read-write lines. If the first signal line 20a of the top memory layer and the second signal line 20c of the bottom memory layer in any two adjacent memory layers 20 are shared as a read-write line, then the second signal line 20c of the top memory layer and the first signal line 20a of the bottom memory layer are both reference voltage lines.

When the first signal line layer and the second signal line layer include the semiconductor material layer 206, the transition conductive material layer 208, and the metal conductive material layer 207 as mentioned above, as shown in FIGS. 1 and 2, then the metal conductive material layer 207 of the first signal line layer in the top memory layer may be shared as the metal conductive material layer 207 of the second signal line layer in the bottom memory layer, and after the common metal conductive material layer 207 is formed, the transition conductive material layer 208 and the semiconductor material layer 206 of the first signal line layer in the top memory layer are formed. When the first signal line layer 20a and the second signal line layer include only the semiconductor material layer 206, the first signal line layer of the top memory layer may be completely shared as the second signal line layer of the bottom memory layer.

In this embodiment, in order to further simplify the manufacturing process, the first signal line 20a of the top memory layer and the second signal line 20c of the bottom memory layer in any two adjacent memory layers 20 may be used as the same signal line when manufacturing the plurality of memory layers 20.

### Second solution

In the second solution, as shown in FIGS. 3 and 5, the transistor 20b is a channel surrounding structure as mentioned above, and the gating line layer is formed on the top side or bottom side of the gate layer 202 in the transistor layer 20b. In order to simplify the manufacturing process, when manufacturing the plurality of memory layers 20, as shown in FIG. 3, the transistors 20b of at least two adjacent memory layers 20 are provided correspondingly in the vertical direction Z. In other words, the positive projections of the adjacent transistors 20b on the substrate 10 in the vertical direction Z overlap or nearly overlap, which facilitates making the gate layers 202 of at least some of the adjacent transistors 20b in the vertical direction Z share the same gating line 20d, thereby reducing the total number of signal lines, to reduce the manufacturing cost while simplifying the manufacturing process.

Referring to FIG. 3, the plurality of memory layers 20 may be divided into at least one common unit GG along the vertical direction Z. Each common unit GG includes two adjacent memory layers 20. For the convenience of the later description, the memory layer 20 in the common unit GG away from the substrate 10 may be defined as the top memory layer, and the memory layer 20 in the common unit GG close to the substrate 10 may be defined as the bottom memory layer. In the common unit GG, the gate layers 202 of two transistors 20b arranged in the vertical direction Z share the same gating line 20d, and the second signal line 20c of the top memory layer and the first signal line 20a of the bottom memory layer are both read-write lines and provided independently to each other, so as to realize the independent control of the read-write state of two memory layers 20 in the common unit GG. It should be understood that if the second signal line 20c of the top memory layer and the first signal line 20a of the bottom memory layer are both read-write lines, the first signal line 20a of the top memory layer and the second signal line 20c of the bottom memory layer are both reference voltage lines.

As shown in FIG. 3, in the common unit GG, the gate layers 202 of two transistors 20b arranged in the vertical direction Z are directly connected to form a common gate layer, and a common gating line 20d is provided on a top side of the common gate layer, but is not limited thereto, may also be provided on a bottom side of the common gate layer. In other embodiments, in the common unit GG, the common gating line 20d may also be provided between the top memory layer and the bottom memory layer, then the gate layers 202 of two transistors 20b arrayed in the vertical direction Z are indirectly connected via the common gating line 20d. Specifically, in the common unit GG, the gating line 20d of the top memory layer is formed on the bottom side of the gate layer 202 of the top memory layer, and the gating line 20d of the bottom memory layer is formed at the top side of the gate layer 202 of the bottom memory layer, and the gating line 20d of the bottom memory layer and the gating line 20d of the top memory layer share at least partially to form the common gating line. For example, the gating line 20d of the bottom memory layer may be completely shared with the gating line 20d of the top memory layer, to reduce costs.

In some embodiments, in the common unit GG, at least a portion of the second signal line 20c in the bottom memory layer is shared as at least a portion of the first signal line 20a in the top memory layer, so that the first signal line 20a of the top memory layer and the second signal line 20c of the bottom memory are used together as the reference voltage line of the common unit GG, which can simplify the process and reduce cost, but is not limited thereto. The first signal line 20a of the top memory layer and the second signal line 20c of the bottom memory layer may also be provided independently to each other, to be used as the reference voltage line or the read-write line of the common unit GG, respectively.

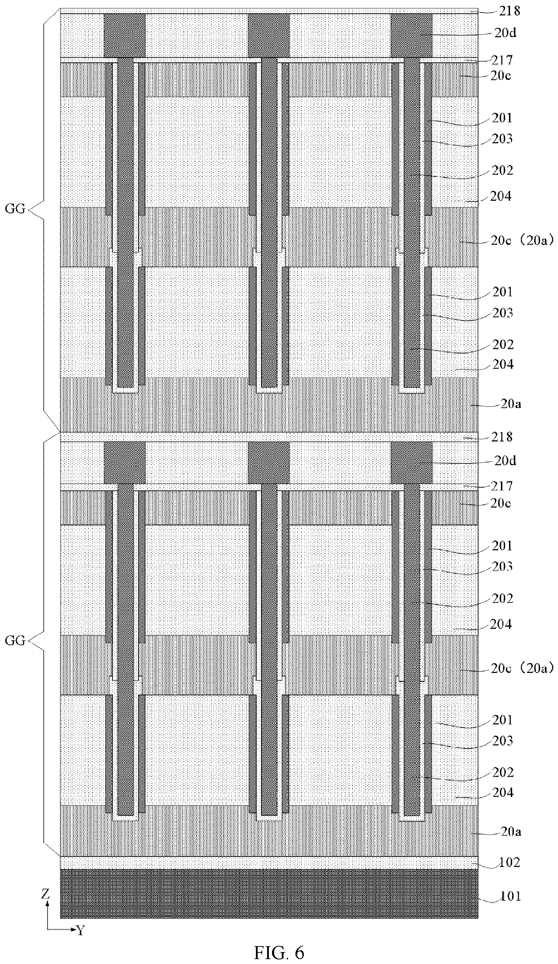

In an optional example, as shown in FIG. 6, there maybe provided a plurality of the common unit GG. In two adjacent common units GG, the read-write lines of one of two adjacent common units GG are provided independently to the read-write lines of the other, such design makes the read-write lines of any two memory layers 20 to be provided independently to each other, so as to facilitate independent control of the read-write state of each memory layer 20.

In an optional example, as shown in FIG. 6, the gate layer 202 of the transistor 20b of one of two adjacent common units GG and the gate layer 202 of the transistor 20b of the other are provided insulated from each other via the isolation insulating layer 218, and the gating lines 20d of one of two adjacent common units GG are provided independently to the gating lines 20d of the other, such that the independent control of adj acent common units GG can be achieved and the difficulty of control can be reduced.

It will be understood that at least one of the read-write line and the gating line may be provided independently to each other between different common units GG to achieve independent operation between different common units GG. Thus, when the gating lines 20d connected to the gate layers 202 between two adjacent common units GG are provided independently to each other, for example, when the gating lines 20d of the common unit GG close to the substrate 10 in two adjacent common units GG are located between the common unit GG close to the substrate 10 and the substrate 10. When the gating line 20d of the common unit GG away from the substrate 10 is located at the side of the common unit GG away from the substrate 10, or when the common gating line 20d in the common unit GG is located between the top memory layer and the bottom memory layer, the read-write lines of which may be partially shared, for example, a top read-write line of the common unit GG close to the substrate 10 and a bottom read-write line of the common unit GG away from the substrate 10 may be shared at least partially, in other words, the adjacent read-write lines of two adjacent common units GG are shared at least partially.

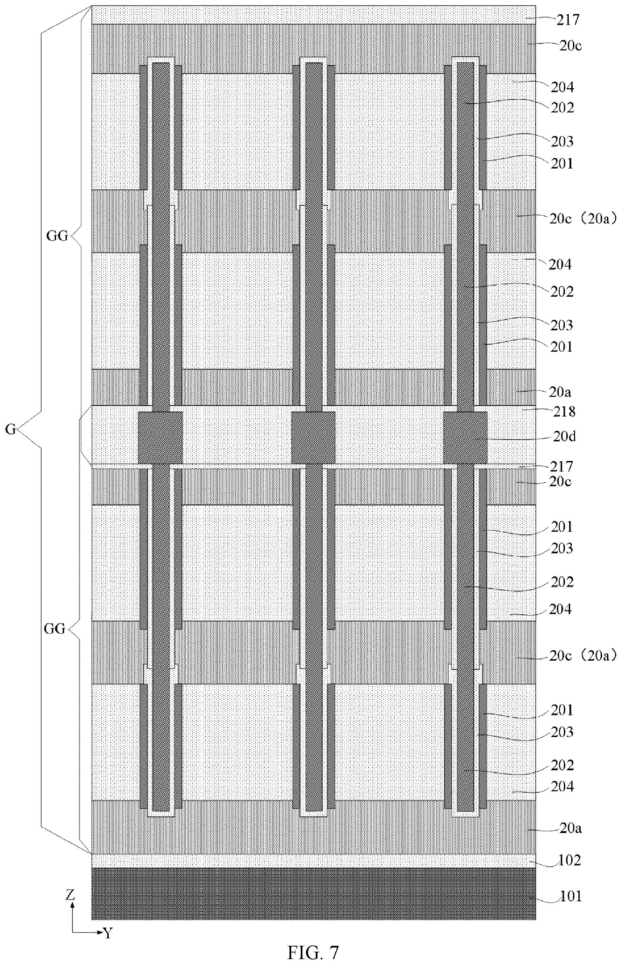

In another optional example, as shown in FIG. 7, the plurality of memory layers 20 may be divided into at least one common group G along the vertical direction Z. The common group G may include two adjacent common units GG. For the convenience of the later description, the common unit GG in the common group G away from the substrate 10 may be defined as the top common unit, and the common unit GG in the common unit G close to the substrate 10 is defined as the bottom common unit. In the common group G, two common unit GG share the same gating line 20d, the gating line 20d is formed on the bottom side of the common gate layer of the top common unit and on the top side of the common gate layer of the bottom common unit, and the read-write line of the top common unit and the read-write line of the bottom common unit are independently to each other, so that while realizing the independent control of each memory layer 20 in the common group G, it is possible to further save the manufacturing of the gating line 20d and reduce the manufacturing cost.

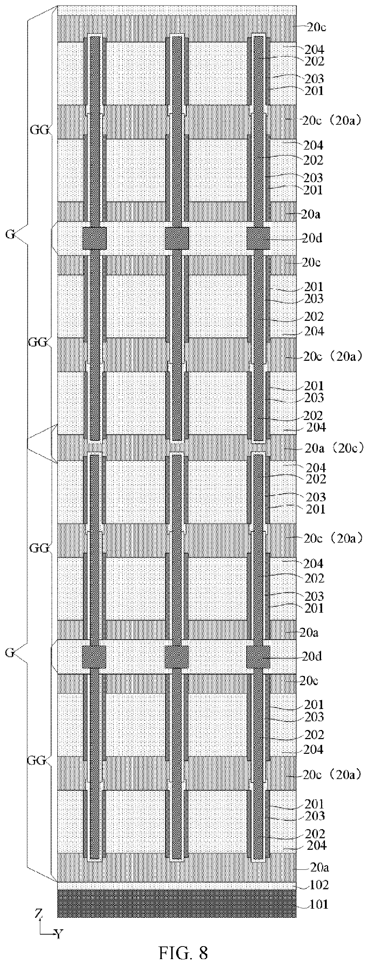

Optionally, as shown in FIG. 8, there maybe provided a plurality of the common groups G, and in two adjacent common groups G, bottom read-write lines of the common group G away from the substrate 10 and top read-write lines of the common group G close to the substrate 10 are shared at least partially, and the gating lines 20d of the common group G away from the substrate 10 and the gating lines 20d of the common group G close to the substrate 10 are independently provided to each other, so that while realizing independent control of each memory layer 20, it is possible to further save the manufacturing of the read-write lines and reduce the manufacturing cost.

Based on any of the above-mentioned embodiments of the present application, the active layer 201 of the transistor 20b is independently provided relative to the substrate 10 of the semiconductor structure, so that compared to the solution of utilizing a portion of the substrate 10 as the active layer 201, a plurality of the memory layers 20 can be provided and stacked in the vertical direction Z, to increase the memory density and reduce the difficulty of the design and the technical cost of the transistor 20b.

In addition, the present application also provides a method of manufacturing a semiconductor structure for manufacturing the semiconductor structure described in any of the foregoing embodiments, the structure, shape, positional relationship with other layers, connection relationship, etc. of each layer in the semiconductor structure can be referred to contents as mentioned above, and will not be repeated herein.

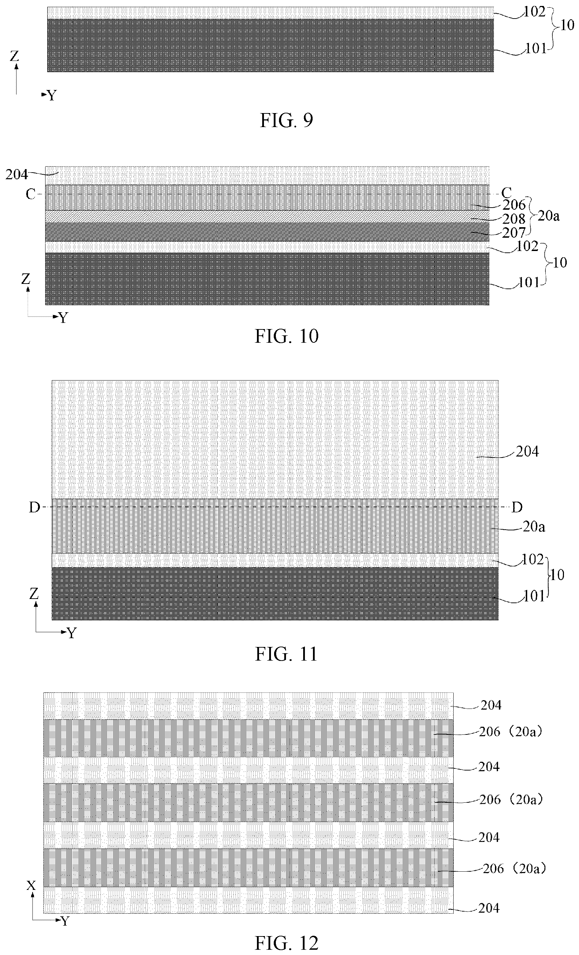

The method of manufacturing the semiconductor structure of the present application may include:
Step S100, providing a substrate 10, for example, which may be a stacked structure, such as shown in FIG. 9, and the substrate 10 may include a single-crystal semiconductor material layer 101 and an insulating isolation layer 102 formed on the single-crystal semiconductor material layer 101;
Step S200, forming at least one memory layer 20 stacked along the vertical direction Z on the substrate 10, as shown in FIGS. 1 to 3 and FIGS. 6 to 8, the method of forming the memory layer 20 includes:
   forming a first signal line layer, a transistor layer, a second signal line layer, and a gating line layer on the substrate 10, the first signal line layer includes a plurality of first signal lines 20a spaced apart, each transistor layer includes a plurality of transistors 20b spaced apart, the second signal line layer includes a plurality of second signal lines 20c spaced apart, and each gating line layer includes a plurality of gating lines 20d spaced apart, one of the first signal line 20a and the second signal line 20c is a reference voltage line and the other is a read-write line, each transistor 20b includes a gate layer 202 and an active layer 201 which is extended in a vertical direction and independently provided relative to the substrate 10; the gate layer 202 is connected to the gating line 20d, the active layer 201 of the transistor 20b is extended in the vertical direction Z and independently provided relative to the substrate 10, a bottom of the active layer 201 is connected to the first signal line 20a, and a top of the active layer 201 is connected to the second signal line 20c.

In the present application, the step of forming the first signal line layer in the bottom memory layer 20 on the substrate 10 may include:
Step S2001, forming a whole metal conductive material film and a semiconductor material film sequentially on the substrate 10 to form a composite conductive film. In Step S2001, a transition conductive material film may also be formed between the metal conductive material film and the semiconductor material film, and the transition conductive material film may be prepared by deposition, or formed by silicification reaction of the metal conductive material film and the semiconductor material film. It is understood that the composite conductive film may include the metal conductive material film, the semiconductor material film, and the transition conductive material film formed between the metal conductive material film and the semiconductor material film.
Step S2002, patterning the composite conductive film to form a plurality of break joints that pass through the composite conductive film. The composite conductive film is divided by the break joints into a plurality of first signal lines 20a spaced apart, and the first signal lines 20a may include a metal conductive material layer 207, a transition conductive material layer 208, and a semiconductor material layer 206 stacked sequentially.

In other embodiments, the step of forming the first signal lines 20a in the bottom memory layer 20 on the substrate 10 may include: after forming a whole semiconductor material film on the substrate 10 sequentially, patterning the semiconductor material film to form a plurality of break joints that pass through the semiconductor material film. The semiconductor material film is divided by the break joints into a plurality of first signal lines spaced apart, and the first signal line layer may include the semiconductor material layer 206.

In other embodiments, the semiconductor material film or the transition conductive material film may not be formed at step S2001 when forming the material layer of the first signal lines 20a, which is determined based on actual situation.

It should be noted that the first signal line 20a produced by the present application may be used as the read-write line, but is not limited thereto, and may also be used as the reference voltage line. When the first signal line 20a is used as the reference voltage line, it is not limited to forming a plurality of reference voltage lines spaced apart by using the above manufacturing method, and it is also possible to not pattern the composite conductive film, and to directly utilize the composite conductive film as an entire surface of the reference voltage lines.

In addition, it should also be understood that in addition to that the first signal line 20a in the bottom memory layer 20 can be fabricated in accordance with the above described steps, the first signal lines 20a in the other memory layers 20 may also be fabricated in accordance with the above described steps or fabricated in other ways, which may be selected according to the actual situation.

In the present application, for transistors 20b of different structures, there are different manufacturing methods in the present application, for example, as described in the second solution and the third solution below.

### Third solution

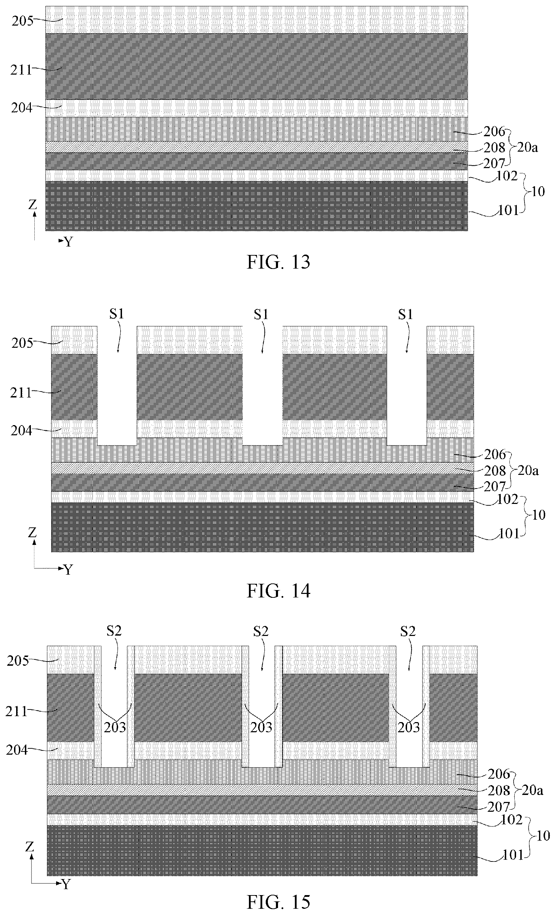

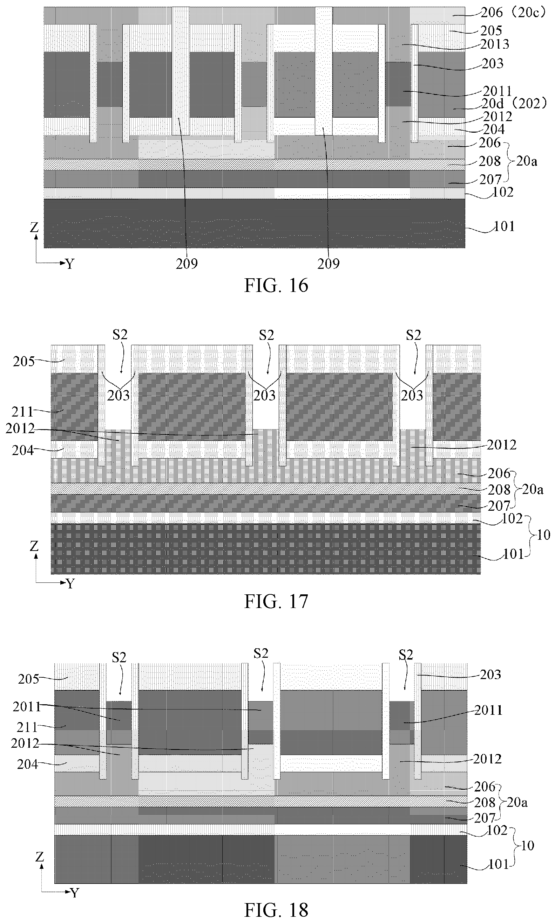

In the third solution, after forming the first signal line layer, a GAA-type transistor layer may be formed on the substrate 10, the step of forming the GAA-type transistor 20b, may include:
Step S2003, forming a first insulating dielectric layer 204 on the substrate 10, the first insulating dielectric layer 204 covers at least a top surface of the first signal line layer 20a, as shown in FIG. 10. It is to be noted that, as shown in FIG. 10 and FIG. 12, when a plurality of the first signal lines 20a are provided and spaced apart, the first insulating dielectric layer 204 may also be formed in the break joints between adjacent first signal lines 20a. In this embodiment, the surface of the first insulating dielectric layer 204 away from the substrate 10 may be polished by a Chemical Mechanical Polishing (CMP) equipment to form a flat surface parallel to the substrate 10, and the flat surface is conducive to the preparation of the subsequent film layer;
Step S2004, sequentially forming a conductive film layer 211 and a second insulating medium layer 205 stacked along the vertical direction Z on the top surface of the first insulating medium layer 204, as shown in FIG. 13. It should be understood that, in this embodiment, the conductive film layer 211 and the second insulating medium layer 205 are a film layer structure covering the whole surface of the first insulating medium layer 204, and the conductive film layer 211 are patterned in subsequently step S2008, whereas in other embodiments, the conductive film layer 211 may be formed and then patterned as a gating line, and then the second insulating dielectric layer 205 of the whole surface is prepared;
Step S2005, forming a filling hole S1 that passes through the second insulating dielectric layer 205, the conductive film layer 211 and the first insulating dielectric layer 204 along the vertical direction Z. The filling hole S1 exposes a portion of the first signal line 20a, as shown in FIG. 14, and it should be noted that a plurality of the filling holes S1 may be provided and spaced apart in the first horizontal direction X and the second horizontal direction Y;
Step S2006, forming a gate insulating layer 203 on an inner wall of the filling holes S1, and the inner wall of the gate insulating layer 203 is formed as a perforative via hole S2 along the vertical direction Z. The via hole S2 exposes a portion of the first signal line 20a, as shown in FIG. 15;
Step S2007, forming an active layer 201 within the via hole S2 of the gate insulating layer 203;
Step S2008, patterning the conductive film layer 211 to form a plurality of gating lines 20d spaced apart, an extension direction of each gating line 20d intersects with that of the read-write line, e.g., the gating line 20d may be extended along the first horizontal direction X, and the read-write line may be extended along the second horizontal direction Y Each gating lines 20d includes at least one gate layer 202, each gate layer 202 at least partially surrounds the active layer 201, and specifically, each gate layer 202 may be completely around the active layer 201, as shown in FIGS. 4 and 16.

Exemplarily, in step S2005, in addition to passing through the second insulating medium layer 205, the conductive film layer 211, and the first insulating medium layer 204, the filling hole S1 may be over-etched into the first signal line layer, for example, the bottom of the filling hole S1 may be embedded within the semiconductor material layer 206 of the first signal line layer, as shown in FIG. 14. That is, in some embodiments, the filling hole S1 is recessed into the surface of the first signal line layer. In other embodiments, when the first signal line layer includes a metal conductive material layer 207, a transition conductive material layer 208, and the semiconductor material layer 206 stacked sequentially, or when the first signal line layer includes the semiconductor material layer 206, the filling hole S1 is recessed into the surface of the semiconductor material layer 206 and doesn't pass through the semiconductor material layer 206.

Exemplarily, in step S2006, specific steps may include:
Step S20061, sequentially forming a silicon oxide film and a silicon nitride film. A portion of the silicon oxide film and the silicon nitride film are sequentially stacked to cover a surface of the second insulating dielectric layer 205 away from the substrate 10, and another portion of the silicon oxide film and the silicon nitride film is provided in the filling hole S1. The silicon oxide film and the silicon nitride film located in the filling hole S1 may be a groove-shaped structure. The groove-shaped structure of the silicon nitride film is located within the groove-shaped structure of the silicon oxide film;
Step S20062, removing groove bottoms of the groove-shaped structures in the silicon nitride film and the silicon oxide film to expose the first signal line 20a;
Step S20063, removing a remaining portion of the groove-shaped structure in the silicon nitride film within the filling hole S1, that is, removing the groove sidewall of the groove-shaped structure in the silicon nitride film, such that the portion of the silicon oxide film retained within the filling hole S1 is formed as the gate insulating layer 203.

In this third solution, in the process of manufacturing the gate insulating layer 203, the silicon nitride film can protect the gate insulating layer 203 formed by the silicon oxide film, thereby improving the quality of the gate insulating layer, and reducing current leakage. In this embodiment, the silicon oxide film is used to form the gate insulating layer 203, but it can be understood that the material in the actual gate insulating layer 203 can be set up depending on the specific needs, and the silicon nitride film can be replaced as the material layer of the gate insulating layer 203 depending on the specific needs.

It should be noted that in the process of forming the gate insulating layer 203, the step S20063 may also be omitted, that is, the groove sidewall of the groove-shaped structure in the silicon nitride film may be retained in the filling hole S1, to form the gate insulating layer 203 together with the portion of the silicon oxide film retained in the filling hole S1. In step S2006, the gate insulating layer 203 may also be formed using other methods known in the field, but is not specifically limited herein.

Exemplarily, in step S2007, a specific step may include: sequentially forming a first electrode region 2012, a channel region 2011, and a second electrode region 2013 within a via hole S2 of the gate insulating layer 203, the top surface of the first electrode region 2012 is higher than the bottom surface of the gate layer 202, the bottom surface of the second electrode region 2013 is lower than the top surface of the gate layer 202, and the conductive types of the first electrode region 2012 and the second electrode region 2013 are the same, and are different from the conductive type of the channel region 2011, as shown in FIG. 16, that is, the active layer 201 formed in step S2007 is the junction active layer.

In the third solution, the first signal line layer as mentioned above may include a semiconductor material layer 206, and the semiconductor material layer 206 of the first signal line layer may be exposed at the via hole S2. Based on this, the step of forming the first electrode region 2012 within the via hole S2 of the gate insulating layer 203 includes: performing an epitaxial growth on the semiconductor material layer 206 of the first signal line layer exposed at the via hole S2 to form the first electrode region 2012. In this embodiment, the semiconductor material layer 206 of the first signal line layer exposed at the via hole S2 is epitaxially grown to form the first electrode region 2012, which is also regarded as constituting an integrated structure with the semiconductor material layer 206 of the first signal line layer, but is not limited herein, a semiconductor material of the same conductive type as the semiconductor material layer 206 of the first signal line layer may also be deposited directly within the via hole S2. It should be understood that after the semiconductor material of the same conductive type as the semiconductor material layer 206 of the first signal line layer is deposited, a portion of the semiconductor material on the inner wall of the via hole S2 and on the top of the second dielectric layer 205 also needs to be removed, to form the first electrode region 2012, as shown in FIG. 17.

For example, in the third embodiment, the step of forming the channel region 2011 within the via hole S2 of the gate insulating layer 203 may include: after the first electrode region 2012 is formed, depositing a semiconductor film of a different conductive type from the first electrode region 2012, and then performing a back-etching process on the semiconductor film to form the channel region 2011 within the via hole S2. The top surface of the channel region 2011 is lower than that of the gate layer 202, as shown in FIG. 18.

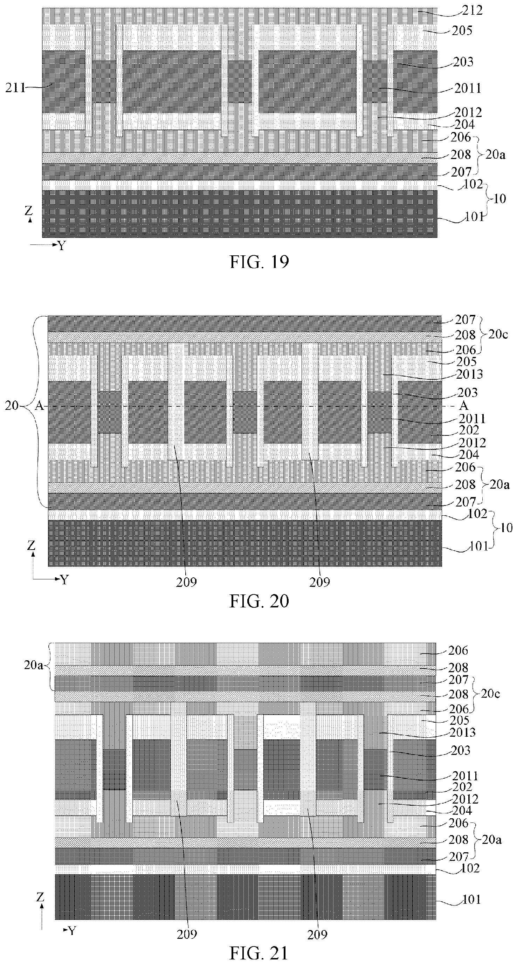

In the third solution, when the second signal line layer includes the semiconductor material layer 206, the semiconductor material layer 206 of the second signal line layer may be formed as an integrated structure with the second electrode region 2013 of the active layer 201. Specifically, after the channel region 2011 of the active layer 201 is formed, a semiconductor film layer 212 of the same conductive type as the semiconductor material layer 206 of the first signal line layer may be formed on the substrate 10. The semiconductor film layer 212 covers the channel region 2011, the gate insulating layer 203, and the second insulating dielectric layer 205, as shown in FIG. 19. The semiconductor film layer 212 may then be patterned to form a plurality of semiconductor sections arranged at intervals, the semiconductor sections include the second electrode region 2013 of the active layer 201 and the semiconductor material layer 206 of the second signal line layer. The second electrode region 2013 of the active layer 201 is filled within the via hole S2, and the semiconductor material layer 206 of the second signal line layer covers the second electrode region 2013, the gate insulating layer 203, and the second insulating dielectric layer 205.

In other embodiments, the semiconductor material layer 206 of the second signal line layer and the second electrode region 2013 of the active layer 201 may also be fabricated separately, which may enable them to have different doping concentrations, or the semiconductor material layer 206 of the second signal line layer may be further doped after integratedly manufacturing the semiconductor material layer 206 of the second signal line layer and the second electrode region 2013 of the active layer 201. It should be understood that the semiconductor material layer 206 is made to have a higher doping concentration, which can reduce the impedance.

In other embodiments, when the transistor 20b is the junctionless transistor, the active layer 201 and the semiconductor material layer 206 of the second signal line layer may be formed by epitaxializing on the upper surface of the semiconductor material layer 206 of the first signal line layer, which may be specifically based on actual situation.

In the present application, the second signal line 20c may be the reference voltage line or the read-write line. If the second signal line 20c made in the present application is used as the reference voltage line, the semiconductor film layer 212 may be patterned by the above mentioned method, and the patterned reference voltage line may be in the same extension direction as the gating line 20d or in a different extension direction from the gating line 20d, which is specifically based on actual situation. In addition, the semiconductor film layer 212 may also be not patterned, and the whole semiconductor film layer 212 can be directly used to connect electrode regions together, that are used to be grounded, of all transistors 20b in the whole memory layer 20, to reduce the steps of the patterning process and reduce the manufacturing cost. If the second signal line 20c made by the present application is used as the read-write line, it not only needs to pattern the semiconductor film layer 212, but also needs to make the extension direction of the whole patterned second signal line 20c different from that of the gating line 20d, for example, while the gating line is extended in the first horizontal direction X, the whole read-write line may be extended in the second horizontal direction Y

For example, in the third solution, when the second signal line 20c is used as the read-write line, the step of forming the second signal line layer may specifically include a step S2009, a step S2010, a step S2011, and a step S2012.

Step S2009, forming a semiconductor film layer 212 of the same conductive type as the semiconductor material layer 206 of the first signal line layer, and the semiconductor film layer 212 covers the channel region 2011, the gate insulating layer 203, and the second insulating dielectric layer 205, as shown in FIG. 19. In other embodiments, the semiconductor film layer 212 may be only filled in the via hole S2, whose upper surface is flush with the upper surface of the second insulating dielectric layer 205, and the semiconductor material layer 206 of the second signal line layer is prepared in a subsequent step S2012.

Step S2010, forming a first break joint extending in the first horizontal direction X and a second break joint extending in the second horizontal direction Y The first break joint passes through the semiconductor film layer 212, the second insulating dielectric layer 205, and the conductive film layer 211 sequentially along the vertical direction Z and is located between adjacent filling holes S1 in the second horizontal direction Y The second break joint passes through the semiconductor film layer 212 and is located between adjacent filling holes S1 in the first horizontal direction X. The conductive film layer 211 forms a plurality of gating lines 20d extending in the first horizontal direction X under the action of the first break joint, and the semiconductor film layer 212 forms a plurality of semiconductor sections spaced apart in the first horizontal direction X and in the second horizontal direction Y under the action of the first break joint and the second break j oint. Each semiconductor section includes a second electrode region 2013 and a semiconductor material layer 206 of the second signal line layer. The second electrode region 2013 is filled in the via hole S2, and the semiconductor material layer 206 of the second signal line layer covers the second electrode region 2013, the gate insulating layer, and the second insulating dielectric layer 205, that is, the step S2010 may include the above mentioned step S2008. Specifically, during the formation of the first break joints, one patterning treatment of the semiconductor film layer 212 is achieved, and a patterning treatment of the conductive film layer 211 is completed, to reduce process steps and reduce the cost. It should be noted that the order of the formation of the first break joint and the second break joint is not specified in this solution, and that the first break joint can be formed before or after the second break j oint, and that the first break joint and the second break joint can also be performed simultaneously.

In other embodiments, when the semiconductor film layer 212 is filled only in the via hole S2, the step of forming the second break joint in step S2010 may be omitted, and other steps involving the second break joint in the subsequent step S2011 may be deleted.

In other embodiments, the conductive film layer 211 has been patterned as the gating line before preparing the second insulating medium layer 205, and the semiconductor material layer 206, the transition conductive material layer 208 and the metal conductive material layer 207 in the second signal line layer are patterned simultaneously.

Step S2011, the insulating filling portion 209 is formed in the first break joint and the second break joint, the top surface of the insulating filling portion 209 is flush with the top surface of the semiconductor section, as shown in FIG. 16. It should be noted that the insulating filling portions 209 in the first and second break joints may be filled simultaneously, or may be filled in a sequential order, for example, after the formation of the second break joint and before the formation of the first break j oint, the second break joint may be filled with the insulating filling portion 209 first, and then after the formation of the first break j oint, the first break joint may be filled with the insulating filling portion 209, but is not limited thereto, or the first break joint may be formed first, and then the first break joint may be filled with the insulating filling portion 209, and then the second break joint may be formed, and then the second break joint may be filled with the insulating filling portion 209, or after the formation of the first break joint and the second break joint, the first break joint and the second break joint are filled with the insulating filling portion 209 simultaneously.

Step S2012, forming transition conductive material layers 208 of a plurality of the second signal lines 20c spaced apart in the first horizontal direction X and extending along the second horizontal direction Y, and metal conductive material layers 207 of the plurality of second signal lines 20c spaced apart in the first horizontal direction X and extending along the second horizontal direction Y. In the second signal line layer, the metal conductive material layers 207 correspond to the transition conductive material layers 208 in the vertical direction Z, and each transition conductive material layer 208 is connected to the top surfaces of a plurality of semiconductor sections arrayed in the second horizontal direction Y Referring to FIG. 20, for example, the transition conductive material layer 208 and the metal conductive material layer 207 in the second signal line layer may be patterned simultaneously to form an elongated structure that extends along the second horizontal direction Y, for example, the transition conductive material film and the metal conductive material film may be formed to cover on the whole surface of the substrate 10, and then the transition conductive material film and the metal conductive material film may be patterned to simultaneously cut out the transition conductive material layer 208 and the metal conductive material layer 207 in the second signal line layer, which reduces the manufacturing cost. In other embodiments, when the semiconductor film layer 212 is only filled in the via hole S2, the semiconductor material layer 206 may be prepared as the second signal line layer in step S2012, or the semiconductor material layer 206, the transition conductive material film, and the metal conductive material film may be prepared by deposition sequentially to prepare the second signal line layer, or the semiconductor material layer 206 and the metal conductive material film may be prepared by deposition sequentially to make both undergo a silicification reaction to form the transition conductive material film, thereby obtaining the second signal line layer, which is dependent on specific situation, without giving too many examples. In this embodiment, in any two adjacent memory layers 20, at least a portion of the second signal line layer in the bottom memory layer is shared as at least a portion of the first signal line layer in the top memory layer, for example, the metal conductive material layer 207 of the second signal line layer in the bottom memory layer may be shared with the first signal line layer in the top memory layer. The first signal line layer in the top memory layer may be formed simultaneously with the transition conductive material layer 208 and the metal conductive material layer 207 in the second signal line layer, specific steps may include:
first forming a first transition conductive material film, a metal conductive material film, a second transition conductive material film, and a semiconductor material film that cover the whole surface of the substrate 10 and are sequentially stacked on the substrate 10. It should be noted that the first transition conductive material film is subsequently patterned to form the transition conductive material layer 208 of the second signal line layer in the bottom memory layer by subsequent patterning, and the metal conductive material film is subsequently patterned to form the transition conductive material layer 207 which is shared with the second signal line layer in the bottom memory layer and the first signal line layer in the top memory layer. The second transition conductive material film and the semiconductor material film are subsequently patterned to form the transition conductive material layer 208 and semiconductor material layer 206 of the first signal line layer in the top memory layer;
Afterwards, the first transition conductive material film, the metal conductive material film, the second transition conductive material film and the semiconductor material film are simultaneously patterned to form a composite linear structure, as shown in FIG. 21. The composite linear structure includes the metal conductive material layer 207 and the transition conductive material layer 208 of the second signal line layer in the bottom memory layer, and the metal conductive material layer 207, the transition conductive material layer 208, and the semiconductor material layer 206 of the first signal line layer in the top memory layer. The metal conductive material layer 207 of the second signal line layer in the bottom memory layer and the metal conductive material layer 207 of the first signal line layer in the top memory layer are a common layer.

In other embodiments, the composite linear structure may include only the semiconductor material layer 206; or the semiconductor material layer 206, the metal conductive material layer 207 and the transition conductive material layer 208 of the second signal line layer and the metal conductive material layer 207, the transition conductive material layer 208 and the semiconductor material layer 206 of the first signal line layer in the top memory layer; or the metal conductive material layer 207 of the second signal line layer in the bottom memory layer and the metal conductive material layer 207 of the first signal line layer in the top memory layer, these material layers are different and electrically connected to each other or insulated from each other, which can be dependent on actual needs.

In other embodiments, it is also possible to pattern the conductive film layer 211 directly after the conductive film layer 211 is formed to form a plurality of gating lines 20d spaced apart. Then, an insulating dielectric layer is deposited to cover the top surface of the gating lines 20d and to fill in the gaps between the adjacent gating lines 20d. Thereafter, the insulating dielectric layer is flattened to stay at the top surface of the gating lines 20d, that is, the portion of the insulating dielectric layer covering the top surface of the gating line layer is removed, and only the portion of the insulating dielectric layer filled between the adjacent gating lines 20d is retained. The retained portion is defined as an isolation portion. Then again, a second insulating dielectric layer 205 is formed to cover whole surfaces of the isolation portion and the gating line layer. It can be understood that the second insulating dielectric layer 205 and the isolation portion may be prepared integrally. After, the above mentioned step S2005, step S2006, and step S2007 are performed sequentially, and the filling hole S1 formed in step S2005 passes through the second insulating dielectric layer 205, the gating line layer, and the first insulating dielectric layer 204 along the vertical direction Z; and after the execution of step S2007, the semiconductor film layer, the transition conductive material film, and the metal conductive material film, which cover the whole surface, may be formed sequentially. Afterwards, the formed whole structure is patterned to form a second signal line layer that intersects with the extension direction of the gating line layer, and second electrode regions 2013 of a row of transistors 20b are formed. The row of transistors 20b herein refer to a plurality of transistors 20b arrayed along the extension direction of the second signal line 20c, i.e., the second electrode regions 2013 of the row of transistors 20b may be integratedly formed with the second semiconductor material layer 206 of the second signal line layer.

In this embodiment, in any two adjacent memory layers 20, the second signal line 20c of the bottom memory layer and the first signal line 20a of the top memory layer are shared, and the common signal line as a whole is defined as a common composite signal line, and there may be a plurality of the common composite signal lines if more than three memory layers 20 of the semiconductor structure in this embodiment are provided. One of the adjacent common composite signal lines in the vertical direction Z is the reference voltage line and the other is the read-write line.

In addition, after the last memory layer 20 (i.e., the memory layer 20 is farthest from the substrate 10) is formed, an insulating cover layer 210 may be formed, as shown in FIG. 1, to cover the second signal line layer of the last memory layer 20. After the insulating cover layer 210 is formed, an over-hole structure (not shown in the figures) may be designed to facilitate leading out the signal lines of each memory layer 20, which will not be described herein.

### Fourth solution

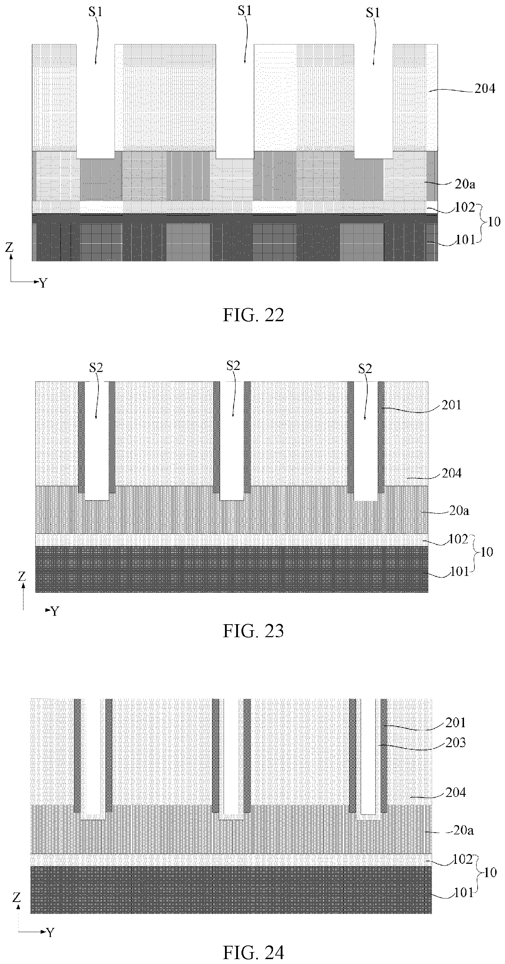

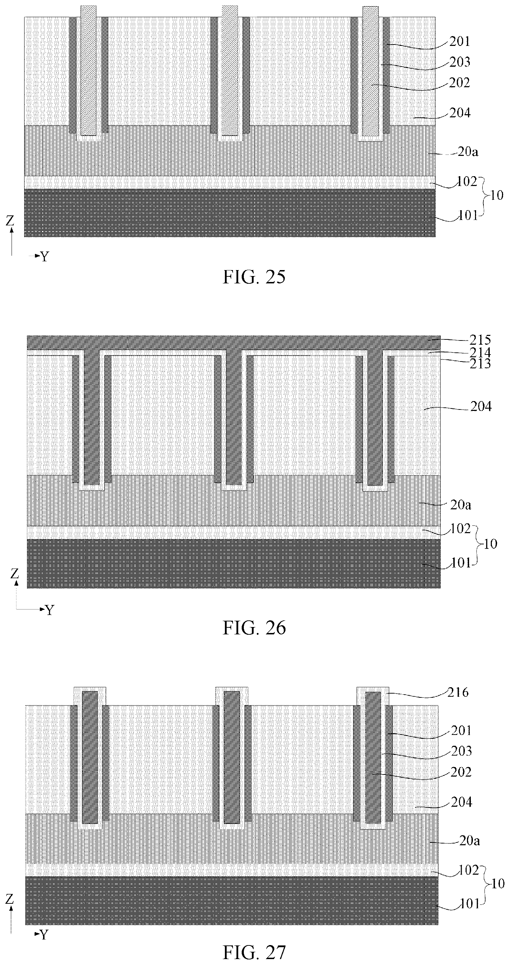

In the fourth solution, after the first signal line layer is formed, a CAA-type transistor layer may be formed on the substrate 10, the step of forming the CAA-type transistor layer may include:
Step S2100, forming a first insulating dielectric layer 204 on the substrate 10. The first insulating dielectric layer 204 covers at least a top surface of the first signal line layer, as shown in FIG. 11. It is to be noted that when a plurality of first signal lines 20a are provided at intervals, as shown in FIG. 11 and FIG. 12, the first insulating dielectric layer 204 may also be formed in the break joint between adjacent first signal lines 20a. In this embodiment, the surface of the first insulating medium layer 204 away from the substrate 10 may be flattened by a Chemical Mechanical Polishing (CMP) equipment to form a flat surface parallel to the substrate 10, which is conducive to the preparation of the subsequent film layer;
Step S2101, forming a filling hole S1 in the vertical direction Z that passes through the first insulating dielectric layer 204. The filling hole S1 exposes a portion of the first signal line layer, as shown in FIG. 22;
Step S2102, forming an annular active layer 201 on an inner wall of the filling hole S1. The inner wall of the annular active layer 201 forms a perforative via hole S2 in the vertical direction Z, and the via hole S2 exposes a portion of the first signal line layer, as shown in FIG. 23;
Step S2103, forming a groove-shaped gate insulating layer 203 within the via hole S2. The groove-shaped gate insulating layer 203 covers the inner wall of the annular active layer 201 and a region in the first signal line layer exposed by the via hole S2, as shown in FIG. 24;
Step S2104, forming a gate layer 202 within a groove of the groove-shaped gate insulating layer 203, as shown in FIG. 25.

It is to be noted that step S2103 and step S2104 may be performed sequentially, but are not limited thereto, and that a gate insulating film material layer 214 and a gate film material layer 215 may also be formed sequentially after step S2102. The gate insulating film material layer 214 includes a planar portion provided on the top surface of the first insulating dielectric layer 204 and a groove portion provided within the filling hole S1. The gate film material layer 215 includes a planar portion provided on the top surface of the gate insulating film material layer 214 and a columnar portion filled within the filling hole S1, as shown in FIG. 26. Then, portions of the gate insulating film material layer 214 and the gate film material layer 215, provided on the top surface of the first insulating dielectric layer 204, are removed so as to simultaneously form the gate layer 202 and the gate insulating layer 203, and as shown in FIG. 25. The top of the second signal line layer may be protuberant, such that the second signal line layer subsequently formed includes a semiconductor material layer, this semiconductor material layer is in contact with the top surface of the active layer 201 and has a different conductive type from the active layer 201, so that the junction formed by the active layer 201 and the semiconductor material layer of the second signal line layer can be covered by the gate layer 202. In some embodiments, when the active layer 201 is the junctionless active layer, and when the conductive types of the semiconductor material layers 206 in contact with the active layer 201 and in the first signal line layer and the second signal line layer are different from the conductive type of the active layer 201, it is necessary to design the gate layer 202 whose bottom is lower than the bottom of the active layer 201, i.e., the bottom of the via hole S2 in step S2102 needs to be embedded in the semiconductor material layer 206 of the first signal line layer, and the bottom of the groove of the gate insulating layer 203 in step S2103 also needs to be lower than the bottom of the active layer 201, and the top of the gate layer 202 needs to be higher than the top of the active layer 201, such that the junction formed between the active layer 201 and the semiconductor material layer 206 of the first signal line layer and the junction formed between the active layer 201 and the semiconductor material layer 206 of the second signal line layer are covered by the gate layer 202. One of the semiconductor material layer 206 of the first signal line layer and the semiconductor material layer 206 of the second signal line 20c may be regarded as a source region of the transistor 20b, and the other may be regarded as a drain region of the transistor 20b.

It should be noted that the junction formed at the source region may or may not be covered by the gate layer 202, but the junction formed at the drain region must be covered by the gate layer 202.

In some embodiments, the gate insulating layer 203 is prepared by deposition, and in some embodiments, the gate insulating layer 203 is formed by oxidising a portion of the inner sidewall of the active layer 201 and the surface of the semiconductor material layer 206 (not shown in the figures) in the first signal line layer. The oxidation method such as an In Situ Steam Generation (ISSG) or thermal oxidation etc.

After forming the gate layer 202 and before forming the second signal line layer, the manufacturing method further includes:
Step S2105, forming an isolation insulating portion 216, as shown in FIG. 27, the isolation insulating portion 216 completely covers the top of the gate layer 202 and exposes at least a portion of the top surface of the annular active layer 201, so that the second signal line layer formed subsequently can be insulated from the gate layer 202 while contacting the top surface of the annular active layer 201.

It should be noted that the CAA transistor has a simple manufacturing process and a low manufacturing cost.

In the present fourth solution, the plurality of memory layers 20 may be divided into at least one common unit GG, each common unit GG includes two adjacent memory layers 20, and the memory layer 20 in the common unit GG away from the substrate 10 is defined as the top memory layer, and the memory layer 20 in the common unit GG close to the substrate 10 is defined as the bottom memory layer. The specific relationship of each layer in the common unit GG may be referred to in the foregoing and will not be repeated herein.

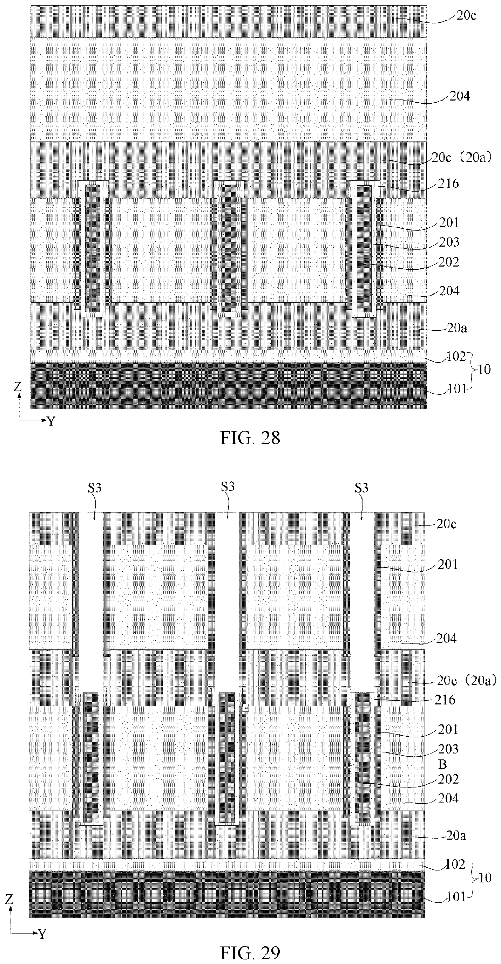

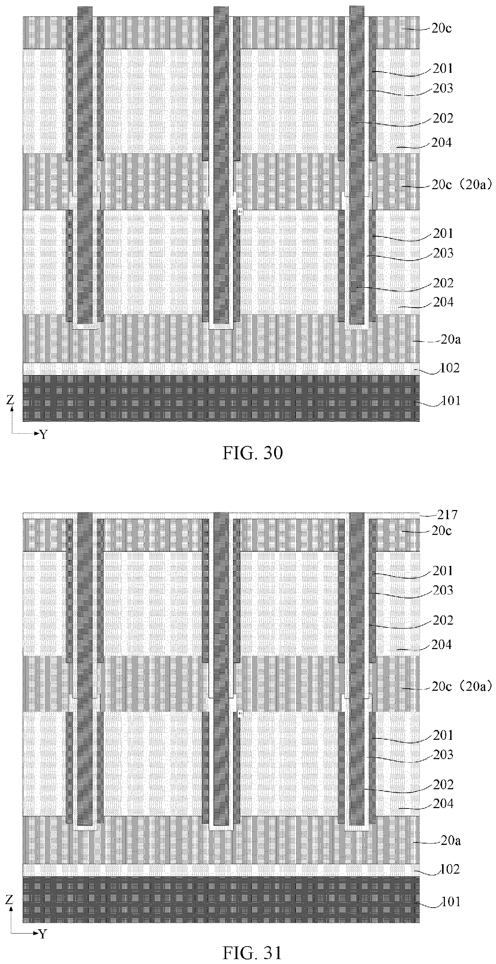

When manufacturing the common unit GG, the manufacturing method further includes:
Step S2106, after forming a reference voltage line (i.e., a first signal line 20a of the top memory layer and a second signal line 20c of the bottom memory layer) of the common unit GG, forming a third insulating medium layer and a top read-write line sequentially, as shown in FIG. 28. The third insulating medium layer refers to a first insulating medium layer 204 of the top memory layer of the common unit GG, and the top read-write line refers to the second signal line 20c of the top memory layer in the common unit GG,
Step S2107, forming a first alignment hole that passes through the top read-write line and the third insulating dielectric layer. The first alignment hole corresponds to the filling hole S1 one-to-one and exposes a portion of the reference voltage line. It should be noted that the size and the manufacturing method of the first alignment hole can be referred to the manufacturing method of the filling hole S1 in FIG. 22. In the present solution, a positive projection of the first alignment hole on the substrate 10 at least partially overlaps with a positive projection of the filling hole S1 on the substrate 10,
Step S2108, forming a groove-shaped active layer on an inner wall of the first alignment hole, the groove-shaped active layer covers the top read-write line and an hole surface of the third insulating dielectric layer and covers a region in the reference voltage line corresponding to the first alignment hole,
Step S2109, forming a second alignment hole S3, as shown in FIG. 29. The second alignment hole S3 passes through a groove bottom of the groove-shaped active layer, the reference voltage line, and the isolation insulating portion 216. The second alignment hole S3 exposes the top surface of the bottom gate layer, which refers to the gate layer 202 of the transistor 20b of the bottom memory layer in the common unit GG,
Step S2110, forming an annular gate insulating layer 203 in an inner wall of the second alignment hole S3. An inner wall of the annular gate insulating layer 203 is formed as a third alignment hole, and the third alignment hole exposes a top surface of the bottom gate layer, a top gate layer is formed in the third alignment hole, the top gate layer fills the third alignment hole and contacts the top surface of the bottom gate layer, as shown in FIG. 30. The top gate layer refers to the gate layer 202 of the transistor 20b of the top memory layer in the common unit GG.

In other embodiments, the second alignment hole S3 is extended at least to pass through the reference voltage line without being extended to the isolation insulating portion 216, or being extended to but not passing through the isolation insulating portion 216, and passes through the isolation insulating portion 216 to expose the top surface of the bottom gate layer when the third alignment hole is formed in step S2110.

Step S2111, forming a fourth insulating dielectric layer 217 that covers the groove-shaped active layer and the top read-write line, as shown in FIG. 31. The fourth insulating dielectric layer 217 exposes the top surface of the top gate layer.

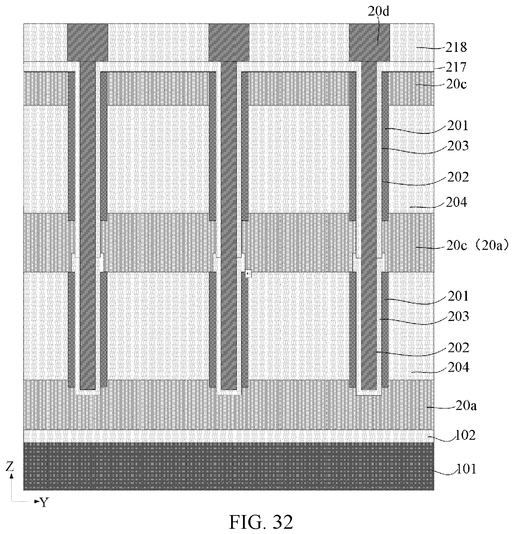

Step S2112, forming a gating line layer on the top surface of the fourth insulating medium layer 217 and in contact with the top surface of the top gate layer, as shown in FIG. 32. The gating line layer is in contact with the top surface of the top gate layer and is insulated from the top active layer (i.e.: the active layer 201 of the top memory layer) and the top read-write line via the fourth insulating medium layer 217.

Exemplarily, in the common unit GG, the active layer 201 is one of the N-type semiconductor and the P-type semiconductor, the top read-write line (i.e., the second signal line 20c of the top memory layer) and the bottom read-write line (i.e., the first signal line 20a of the bottom memory layer) both include semiconductor material layers, and the semiconductor material layers of the top read-write line and the bottom read-write line are the other of the N-type semiconductor and the P-type semiconductor. The groove bottom of the groove-shaped gate insulating layer in the bottom memory layer is embedded in the semiconductor material layer of the bottom read-write line, and the top surface of the groove bottom of the groove-shaped gate insulating layer is lower than the bottom surface of the active layer 201 in the bottom memory layer, so that the bottom surface of the common gate layer is lower than the bottom surface of the active layer 201 in the bottom memory layer, such that the PN junction formed by the bottom active layer (i.e., the active layer 201 of the bottom memory layer) and the semiconductor material layer of the bottom read-write line 201 is covered by the common gate layer.

In a positive projection of the substrate 10, the gating line layer covers the boundary of the first alignment hole, such that the PN junction formed by the bottom active layer (i.e., the active layer 201 of the top memory layer) and the semiconductor material layer of the top read-write line is covered by the gating line layer. In this embodiment, the fourth insulating medium layer 217 may be provided between the gating line layer and the semiconductor material layer of the top read-write line. The step S2111 is performed during performing step S2110. The fourth insulating dielectric layer 217 and the annular gate insulating layer are prepared in the same layer, to form a continuous and equal thickness film layer, and then the step of preparing the top gate layer in step S2110 is performed.

In other embodiments, the fourth insulating dielectric layer 217 may not be prepared in the same layer as the annular gate insulating layer, for example, after sequentially forming the annular gate insulating layer and the top gate layer, the fourth insulating dielectric layer 217 covering the top gate layer, the annular gate insulating layer 203, the groove-shaped active layer, and the top read-write line is formed first, and then the fourth insulating dielectric layer 217 is patterned to expose the top surface of the top gate layer, afterwards, step S2112 is performed.

In other embodiments, after step S2112, the method of manufacturing the common unit GG may also include:
Step S2113, forming an isolation insulating layer 218 that covers at least the fourth insulating dielectric layer 217 and is filled between adjacent gating lines 20d, as shown in FIG. 32.

In other embodiments, when the first signal line 20a of the bottom memory layer and the second signal line 20c of the top memory layer are the read-write lines and a composite line layer. The composite line layer is formed by a semiconductor material layer of a different conductive type from the active layer 201, a metal material layer, and a transition metal material layer. The semiconductor material layer is in contact with the active layer 201 to form a PN junction.

There may be provided a plurality of the common units GG of the fourth solution. Two adjacent common units GG may be formed completely and independently to each other, that is, after the step S2114 is formed, the steps S2106 to the step S2114 may be repeated many times to make the plurality of common units GG.

It should be understood that the plurality of common units GG are not limited to the aforementioned independent formation, but may also form at least one common group G as mentioned above. The method of manufacturing the common group G may include the aforementioned steps S2106 to step S2114. The aforementioned steps S2106 to step S2114 are used to form the bottom common unit of the common group G. After step S2114 is formed, the top common unit is formed. It should be noted that the first signal line 20a of the bottom memory layer in the top common unit needs to be insulated from the gating line 20d, and thus the isolation insulating layer 218 prepared in step S2114 may cover the top surface of the gating line 20d, in addition to covering the fourth insulating dielectric layer 217 and being filled between the adjacent gating lines 20d.

In this embodiment, the overall formation steps of the top common unit and the bottom common unit in the common group G may be similar, but since the top common unit needs to share the gating lines 20d with the bottom common unit, thus when forming the filling hole S1 of the bottom memory layer in the top common unit, the filling hole S1 needs to pass through the first signal line layer of the bottom memory layer in the top common unit and the isolation insulating layer 218 in the top common unit, to expose the gating line 20d of the bottom common unit, so as to facilitate making the gate layer 202 of the top common unit to be in contact with the gating line 20d when the gate layer 202 of the top common unit is manufactured subsequently, thereby realizing the solution that the two common units GG in the common group G share the same gating line 20d. In addition, the remaining steps of the top common unit can be referred to the manufacturing method of each layer in the bottom common unit in the fourth solution, which will not be described in detail herein.

When there is no common structure in the adjacent memory layers 20, the method of manufacturing the single memory layer 20 may include: forming a first signal line layer, a first insulating medium layer 204, and a second signal line layer sequentially, and then forming a via hole passing through the second signal line layer, the first insulating medium layer 204, and the first signal line layer; and then forming an active layer 201 and a gate insulating layer 203 in the via hole; afterwards, forming the gate layer 202 and the gating lines 20d are formed, and the gate layer 202 and the gating lines 20d integratedly or separately. It should be noted that the method of manufacturing the single memory layer 20 is not limited to this, as long as it is possible to fabricate the CAA structure of this embodiment.

In the present application, the terms "first", "second", "third", "fourth", etc. are used only for descriptive purposes, and are not to be understood as indicating or implying relative importance or implicitly specifying the number of technical features indicated. As a result, features defined as "first", "second", "third", "fourth" may expressly or implicitly include one or more technical features. In the description of the present application, "plurality" means two or more, unless otherwise expressly and specifically limited.

In the description of the present specification, the terms "some embodiments", "exemplarily", etc. mean that the specific features, structures, materials, or characteristics described in conjunction with the embodiments or examples are included in at least one embodiment or example of the present application. In this specification, schematic expressions of the above terms do not necessarily refer to the same embodiment or example. Moreover, the specific features, structures, materials, or characteristics described may be combined in a suitable manner in any one or more of the embodiments or examples. Moreover, without contradicting each other, those skilled in the art may combine and combine different embodiments or examples and features of different embodiments or examples described in this specification.

## Claims

1. A semiconductor structure, comprising:
a substrate (10); and
at least one memory layer (20), stacked on a same side of the substrate (10) in a vertical direction, wherein the memory layer (20) comprises at least a first signal line layer, at least one transistor layer, a second signal line layer, and at least one gating line layer, wherein the first signal line layer comprises a plurality of first signal lines (20a) spaced apart, each transistor layer comprises a plurality of transistors (20b) spaced apart, the second signal line layer comprises a plurality of second signal lines (20c) spaced apart, and each gating line layer comprises a plurality of gating lines (20d) spaced apart, one of the first signal line (20a) and the second signal line (20c) is a reference voltage line and another one of the first signal line (20a) and the second signal line (20c) is a read-write line;
wherein each transistor (20b) comprises a gate layer (202) and an active layer (201) which is extended in a vertical direction and independently provided relative to the substrate (10);
wherein the gate layer (202) is connected to the gating line (20d); wherein a bottom of the active layer (201) is connected to the first signal line (20a), and a top of the active layer (201) is connected to the second signal line (20c);
wherein in the memory layer (20):
a plurality of transistors (20b) are arrayed in a first horizontal direction and a second horizontal direction, and the first horizontal direction intersects with the second horizontal direction;
a plurality of read-write lines are arranged at intervals in the first horizontal direction, and each read-write line is extended in the second horizontal direction and is connected to the active layer (201) of each transistor (20b) arranged in the second horizontal direction; and
a plurality of gating lines (20d) are arranged at intervals in the second horizontal direction, and each gating line (20d) is extended in the first horizontal direction and connected to the gate layer (202) of each transistor (20b) arranged in the first horizontal direction.

2. The semiconductor structure according to claim 1, wherein the transistor (20b) comprises:
a core layer, extending in the vertical direction;
a sleeve layer, surrounding at least an outer peripheral side of the core layer, wherein one of the core layer and the sleeve layer is the active layer (201) of the transistor (20b), and another one of the core layer and the sleeve layer is the gate layer (202) of the transistor (20b); and
a gate insulating layer (203), filled between the gate layer (202) and the active layer (201).

3. The semiconductor structure according to claim 2, wherein the core layer is the active layer (201) and the sleeve layer is the gate layer (202);
wherein the gating line layer is formed on a side of the second signal line layer close to the substrate (10), a first insulating dielectric layer (204) is formed between the gating line layer and the first signal line layer, and a second insulating dielectric layer (205) is formed between the gating line layer and the second signal line layer, and the gate layer (202) of the transistor (20b) belongs to a part of the gating line (20d).

4. The semiconductor structure according to claim 3, wherein gating lines (20d) of any two of a plurality of the memory layers (20) are provided independently to each other, and in at least two adjacent memory layers (20):
the memory layer (20) away from the substrate (10) is defined as a top memory layer (20), and the memory layer (20) close to the substrate (10) is defined as a bottom memory layer (20), wherein at least a portion of the second signal line (20c) in the bottom memory layer (20) is shared as at least a portion of the first signal line (20a) in the top memory layer (20).

5. The semiconductor structure according to claim 2, wherein the core layer is the gate layer (202) and the sleeve layer is the active layer (201);
wherein the gating line layer is formed on a top side or a bottom side of the gate layer (202).

6. The semiconductor structure according to claim 5, wherein a plurality of the memory layers (20) are divided into at least one common unit (GG) in the vertical direction, and the common unit (GG) comprises two adjacent memory layers (20), and the memory layer (20) in the common unit (GG) away from the substrate (10) is defined as a top memory layer (20), and the memory layer (20) in the common unit (GG) close to the substrate (10) is defined as a bottom memory layer (20), wherein in the common unit (GG):
gate layers (202) of two transistors arranged in the vertical direction share a same gating line (20d), and the second signal line (20c) of the top memory layer (20) and the first signal line (20a) of the bottom memory layer (20) are the read-write lines and are provided independently to each other.

7. The semiconductor structure according to claim 6, wherein
in the common unit (GG), the gate layers (202) of two transistors arranged in the vertical direction are directly connected to form a common gate layer (GG), and the at least one gating line (20d) is located on a top side or a bottom side of the common gate layer; or
in the common unit (GG), the gating line (20d) of the top memory layer (20) is formed on the bottom side of the gate layer (202) of the top memory layer (20), the gating line (20d) of the bottom memory layer (20) is formed on the top side of the gate layer (202) of the bottom memory layer (20), and the gating line (20d) of the bottom memory layer (20) and the gating line (20d) of the top memory layer (20) share at least partially.

8. The semiconductor structure according to claim 7, wherein in the common unit (GG), the gate layers (202) of two transistors (20b) arranged in the vertical direction are directly connected to form a common gate layer (202), and the gating line (20d) is located on the top side or the bottom side of the common gate layer;
wherein a plurality of the memory layers (20) are divided into at least one common group (G) in the vertical direction, wherein the common group (G) comprises two adjacent layers of the common units (GG), the common units (GG) in the common group (G) are defined as a top common unit (GG) away from the substrate (10), and the common units (GG) close to the substrate (10) are defined as a bottom common unit (GG); and
wherein in the common group (G), two layers of the common units (GG) share a same gating line (20d), the gating line (20d) is formed on the bottom side of the common gate layer (202) in the top common unit (GG) and on the top side of the common gate layer (202) in the bottom common unit (GG), and the read-write lines of the top common unit (GG) and the read-write lines of the bottom common unit (GG) are provided independently to each other.

9. The semiconductor structure according to claim 8, wherein
a plurality of the common groups (G) are provided,
in two adjacent common groups (G):
read-write lines of a bottom in the common group (G) away from the substrate (10) and read-write lines of a top in the common group (G) close to the substrate (10) share at least partially; and
the gating line (20d) of the common group (G) away from the substrate (10) and the gating line (20d) of the common group (G) close to the substrate are provided independently to each other.

10. A method of manufacturing a semiconductor structure, comprising:
providing a substrate (10);
forming at least one memory layer (20) stacked on the substrate (10) in a vertical direction, wherein a method of forming each memory layer (20) comprises:
forming a first signal line layer, at least one transistor layer, a second signal line layer, and at least one gating line layer on the substrate (10), wherein the first signal line layer comprises a plurality of first signal lines (20a) spaced apart, each transistor layer comprises a plurality of transistors (20b) spaced apart, the second signal line layer comprises a plurality of second signal lines (20c) spaced apart, and each gating line layer comprises a plurality of gating lines (20d) spaced apart, one of the first signal line (20a) and the second signal line (20c) is a reference voltage line and another one of the first signal line (20a) and the second signal line (20c) is a read-write line; wherein the transistor (20b) comprises a gate layer (202) and an active layer (201) which is extended in a vertical direction and independently provided relative to the substrate (10); wherein the gate layer (202) is connected to the gating line (20d); wherein a bottom of the active layer (201) is connected to the first signal line (20a), and a top of the active layer (201) is connected to the second signal line (20c).

11. The method of manufacturing the semiconductor structure according to claim 10, wherein the forming the transistor (20b) on the substrate (10)comprises:
forming a first insulating dielectric layer (204) on the substrate (10), wherein the first insulating dielectric layer (204) covers at least a top surface of the first signal line layer;
forming a conductive film layer (211) and a second insulating dielectric layer (205) that are sequentially stacked in the vertical direction on a top surface of the first insulating dielectric layer (204);
forming a filling hole (S1) that passes through the second insulating dielectric layer (205), the conductive film layer (211) and the first insulating dielectric layer (204) in the vertical direction, wherein the filling hole (S1) exposes a portion of the first signal line (20a);
forming an annular gate insulating layer (203) in an inner wall of the filling hole (S1), wherein an inner wall of the gate insulating layer (203) forms a perforative via hole (S2) in the vertical direction, and the via hole (S2) exposes a portion of the first signal line (20a);
forming an active layer (201) within the via hole (S2) of the gate insulating layer (203); and
patterning the conductive film layer (211) to form a plurality of gating lines (20d) spaced apart, wherein the projection of the gating line (20d) in the horizontal plane intersects with the projection of the extension direction of the read-write line in the horizontal plane;
wherein each gating line (20d) comprises at least one gate layer (202), and each gate layer (202) is provided at least partially around one active layer (201).

12. The method of manufacturing the semiconductor structure according to claim 11, wherein the forming the active layer (201) comprises: forming a first electrode region (2012), a channel region (2011) and a second electrode region (2013) in sequence within the via hole (S2) of the gate insulating layer (203); and
wherein a top surface of the first electrode region (2012) is higher than a bottom surface of the gate layer (202), and a bottom surface of the second electrode region (2013) is lower than a top surface of the gate layer (202), and conductive types of the first electrode region (2012) and the second electrode region (2013) are the same and are different from a conductive type of the channel region (2011).

13. The method of manufacturing the semiconductor structure according to claim 12, wherein each second signal line (20c) comprises the semiconductor material layer (206) and a metal conductive material layer (207) stacked on the substrate (10), and a transition conductive material layer (208) provided between the semiconductor material layer (206) and the metal conductive material layer (207); and the semiconductor material layer (206) of the second signal line (20c) is in direct contact or integrally formed with the second electrode region (2013) of the active layer (201);
wherein the forming the second signal line (20c)when the second signal line (20c) is used as the read-write line comprises:
forming a semiconductor film layer (212) of the same conductive type as the semiconductor material layer (206) of the first signal line (20a), wherein the semiconductor film layer (212) covers the channel region, the gate insulating layer (203), and the second insulating dielectric layer (205);
forming a first break joint that extends in a first horizontal direction and a second break joint extending in a second horizontal direction, wherein the first break joint passes through the semiconductor film layer (212), the second insulating dielectric layer (205) and the conductive film layer (211) in the vertical direction in turn, and is located between adjacent the filling holes (S1) in the second horizontal direction; wherein the second break joint passes through the semiconductor film layer (212) and is located between adjacent the between the filling holes (S1) in the first horizontal direction, and the conductive film layer (211) forms a plurality of gating lines (20d) extending in the first horizontal direction under an action of the first break joint; wherein the semiconductor film layer (212) forms a plurality of semiconductor sections spaced apart in the first horizontal direction and in the second horizontal direction under the action of the first break joint and the second break joint, and each semiconductor section comprises the second electrode region (2013) and a semiconductor material layer (206) of the second signal line (20c), the second electrode region (2013) is filled in the via hole (S2), and the semiconductor material layer (206) of the second signal line (20c) covers the second electrode region (2013), the gate insulating layer (203) and the second insulating dielectric layer (205);
forming an insulating filling section (209) in the first break j oint and the second break j oint, and a top surface of the insulating filling section (209) is flush with a top surface of the semiconductor section; and
forming a plurality of transition conductive material layers (208) of the second signal lines (20c) spaced apart in the first horizontal direction and extending in the second horizontal direction and a plurality of metal conductive material layers (207) of the second signal lines (20c) spaced apart in the first horizontal direction and extending in the second horizontal direction, wherein in the second signal line layer, the plurality of metal conductive material layers (207) correspond one-to-one in the vertical direction with the plurality of transition conductive material layers (208), and each transition conductive material layer (208) is in contact with top surfaces of a plurality of the semiconductor sections arrayed in the second horizontal direction.

14. The method of manufacturing the semiconductor structure according to claim 10, wherein the forming the transistor (20b) on the substrate (10) comprises:
forming a first insulating dielectric layer (204) on the substrate (10), wherein the first insulating dielectric layer (204) covers at least the top surface of the first signal line (20a);
forming a filling hole (S 1) that passes through the first insulating dielectric layer (204) in the vertical direction, wherein the filling hole (S 1) exposes a portion of the first signal line (20a);
forming an annular active layer (201) in an inner wall of the filling hole (S1), wherein an inner wall of the annular active layer (201) forms a perforative via hole (S2) in the vertical direction, and the via hole (S2) exposes a portion of the first signal line (20a);
forming a groove-shaped gate insulating layer (203) within the via hole (S2), wherein the groove-shaped gate insulating layer (203) covers the inner wall of the annular active layer (201) and a region of the first signal line (20a) exposed by the via hole (S2); and
forming a gate layer (202) within a groove of the groove-shaped gate insulating layer (203).

15. The method of manufacturing the semiconductor structure according to claim 44, wherein after forming the gate layer (202) and before forming the second signal line (20c), the method of manufacturing the semiconductor structure further comprises:
forming an isolating insulating portion (216), wherein the isolating insulating portion (216) completely covers the top of the gate layer (202) and exposes at least a portion of a top surface of the annular active layer (201);
wherein a plurality of memory layers (20) are divided into at least one common unit (GG), each common unit (GG) comprises two adjacent memory layers (20), and the memory layer (20) in the common unit (GG) away from the substrate (10) is defined as a top memory layer (20), and the memory layer (20) in the common unit (GG) close to the substrate (10) is defined as a bottom memory layer (10);
wherein in the common unit (GG), gate layers (202) of two transistors (20b) arranged in the vertical direction are connected to form a common gate layer (202) and share a same gating line (20d), and at least a portion of the first signal line (20a) in the top memory layer (20) and at least a portion of the second signal line (20c) in the bottom memory layer (20) are shared, so that the first signal line (20a) of the top memory layer (20) and the second signal line (20c) of the bottom memory layer (20) are together used as a reference voltage line of the common unit (GG), the second signal line (20c) of the top memory layer (20) and the first signal line (20a) of the bottom memory layer (20) each is the read-write line and provided independently to each other, and when the manufacturing the common unit (GG), the method further comprises:
forming a third insulating dielectric layer (204) and a top read-write line in sequence after forming the reference voltage line of the common unit (GG);
forming first alignment holes that pass through the top read-write line and the third insulating dielectric layer (204), and first alignment holes correspond one-to-one to filling holes (S 1) and expose a portion of the reference voltage line;
forming a groove-shaped active layer (201) in an inner wall of the first alignment hole, wherein the groove-shaped active layer (201) covers hole surfaces of the top read-write line and the third insulating dielectric layer (201), and a region of the reference voltage line corresponding to the first alignment hole;
forming a second alignment hole (S3), wherein the second alignment hole (S3) passes through at least a groove bottom of the groove-shaped active layer (201) and the reference voltage line from an inner sidewall of the groove-shaped active layer (201);
forming an annular gate insulating layer (203) in an inner wall of the second alignment hole (S3), wherein the inner wall of the annular gate insulating layer (203) forms a third alignment hole, and the third alignment hole exposes a top surface of a bottom gate layer (202), a top gate layer (202) is formed in the third alignment hole, and the top gate layer (202) is in contact with the top surface of the bottom gate layer (202);
forming a fourth insulating dielectric layer (207) covering the groove-shaped active layer (201) and the top read-write line, wherein the fourth insulating dielectric layer (207) exposes a top surface of the top gate layer (202); and
forming at least one gating line (20d) on a top surface of the fourth insulating dielectric layer (207) in contact with the top surface of the top gate layer (202).
